(19) Europäisches Patentamt
European Patent Office
Office européen des brevets

(11) EP 4 223 853 A1

(12) EUROPEAN PATENT APPLICATION

(43) Date of publication:
**09.08.2023 Bulletin 2023/32**

(21) Application number: **22155250.8**

(22) Date of filing: **04.02.2022**

(51) International Patent Classification (IPC):
***C09K 11/06*** *(2006.01)* ***H01L 51/50*** *(2006.01)*

(52) Cooperative Patent Classification (CPC):
**C09K 11/06; H10K 85/654; H10K 85/6572;**
C09K 2211/1007; C09K 2211/1044;
C09K 2211/1059; H10K 50/11

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Samsung Display Co., Ltd.**
**Gyeonggi-do 17113 (KR)**

(72) Inventors:
- **Joly, Damien**
**67930 Beinheim (FR)**
- **Duy, Cong Le**
**76646 Bruchsal (DE)**

(74) Representative: **Ruttekolk, Ivo Robert**
**Patentanwälte Isenbruck Bösl Hörschler PartG mbB**
**Eastsite One**
**Seckenheimer Landstraße 4**
**68163 Mannheim (DE)**

Remarks:
Amended claims in accordance with Rule 137(2) EPC.

# (54) ORGANIC ELECTROLUMINESCENT DEVICES

(57) The present invention relates to a light-emitting layer for use in an organic electroluminescent device, wherein the light-emitting layer is obtained from coevaporation of a composition comprising a mixture of two structurally different compounds both having an evaporation temperature between 150 to 400 °C. Furthermore, the invention refers to a method for preparing such light-emitting layer.

EP 4 223 853 A1

## Description

The present invention relates to a light-emitting layer for use in an organic electroluminescent device, wherein the light-emitting layer is obtained from co-evaporation of a composition comprising a mixture of two structurally different compounds both having an evaporation temperature between 150 to 400 °C. Furthermore, the invention refers to a method for preparing such light-emitting layer. Moreover, the present invention relates to a composition of a mixture of two materials that can be advantageously used in organic light emitting devices and enable the fabrication of light emitting layer comprising multiple components, in particular four or more components. The present invention relates to a selection of two materials with different properties which can be simultaneously evaporated and allow the production of organic electroluminescent devices with increased lifetime. The simultaneous evaporation of two materials leads to a homogenous deposition which facilitate the fabrication process of an electroluminescent device which contains more than three compounds in the emission layer.

Description

Organic electroluminescent devices containing one or more light-emitting layers based on organics such as, e.g. organic light-emitting diodes (OLEDs), light-emitting electrochemical cells (LECs) and light-emitting transistors gain increasing importance. In particular, OLEDs are promising devices for electronic products such as e.g. screens, displays and illumination devices. In contrast to most electroluminescent devices essentially based on inorganics, organic electroluminescent devices based on organics are often rather flexible and producible in particularly thin layers. The OLED-based screens and displays already available today bear either good efficiencies and long lifetimes or good color purity and long lifetimes, but do not combine all three properties, i.e. good efficiency, long lifetime, and good color purity.

The color purity or color point of an OLED is typically provided by CIEx and CIEy coordinates, whereas the color gamut for the next display generation is provided by so-called BT-2020 and DCPI3 values. Generally, in order to achieve these color coordinates, top emitting devices are needed to adjust the color coordinate by changing the cavity. In order to achieve high efficiency in top emitting devices while targeting these color gamut, a narrow emission spectrum in bottom emitting devices is needed.

State-of-the-art phosphorescence emitters exhibit a rather broad emission, which is reflected by a broad emission of phosphorescence-based OLEDs (PHOLEDs) with a full width half maximum (FWHM) of the emission spectrum, which is typically larger than 0.25 eV. The broad emission spectrum of PHOLEDs in bottom devices, leads to high losses in out-coupling efficiency for top emitting device structure while targeting BT-2020 and DCPI3 color gamut.

Additionally, phosphorescence materials are typically based on transition metals, e.g. iridium, which are quite expensive materials within the OLED stack due to their typically low abundance. Thus, transition metal based materials have the most potential for cost reduction of OLEDs. Lowering of the content of transition metals within the OLED stack thus is a key performance indicator for pricing of OLED applications.

Recently, some fluorescence or thermally activated delayed fluorescence (TADF) emitters have been developed that display a rather narrow emission spectrum, which exhibits an FWHM of the emission spectrum, which is typically smaller than or equal to 0.25 eV, and therefore more suitable to achieve BT-2020 and DCPI3 color gamut. However, such fluorescence and TADF emitters typically suffer from low efficiency due to decreasing efficiencies at higher luminance (i.e. the roll-off behaviour of an OLED) as well as low lifetimes due to for example the exciton-polaron annihilation or exciton-exciton annihilation.

Doped light-emitting layers of prior art organic light-emitting devices have been formed by co-deposition from two independently controlled evaporation deposition sources, also referred to as container. A container may be any container usable as a source for (co-)evaporation of the first compound and second compound. Optionally, such container may be a crucible. In an evaporation deposition process useful for forming a doped organic light-emitting layer, the concentration of the luminescent dopant in the host-layer being formed was controlled by controlling the rate of evaporation of the dopant material from the dopant deposition source and by controlling the rate of evaporation deposition of the host material from the host deposition source. Such independently controlled co-evaporation has been effective in producing doped organic light-emitting devices of acceptable efficiency of light-emission in a research and device development environment. However, there are at least two disadvantages of the aforementioned co-deposition process which could be overcome by the present invention. One disadvantage is the accurate control of the deposition rates of the compounds used in the light-emitting layer, particularly when relatively low concentration levels of 0.01 to 0.1 mole percent of dopant were to be incorporated in a doped layer of a host material. Another disadvantage is that co-evaporation is relatively wasteful in terms of material utilization in that each of the evaporation co-deposition sources must be activated and adjusted to a desired vapor flux prior to the onset of layer formation over a previously formed organic layer of the device. Usually, a mechanic shutter is used to protect the device until such time as required to adjust the vapor flux of the host material and the vapor flux of the dopant material. Waste of such materials not only increases the cost of a device, but also increases the difficulty of maintenance of an evaporation deposition system.

Co-evaporation of host compounds and phosphorescent emitters out of one container has been taught in EP-A 1156536 and US 10,074,806.

Surprisingly, it has been found that an organic electroluminescent device's light-emitting layer wherein two compounds are evaporated simultaneously out of one container as a premixed composition not only overcomes the disadvantages of the prior art listed above, but also provides increased lifetime compared to organic electroluminescent device's light-emitting layer where all compounds of the light-emitting layer are co-evaporated out of individual containers for each compound.

The present invention relates to an organic electroluminescent device comprising one or more light-emitting layers, wherein the light-emitting layer is obtained from evaporation of a composition comprising a mixture of a first compound and a second compound, which are provided in one container; wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure between $1\times10^{-6}$ Torr to $1\times10^{-8}$ Torr (preferably measured at (approximately) $1\times10^{-7}$ Torr); wherein the temperature difference T1-T2 is in a range between -40 °C to 40 °C, preferably between -20 °C and 20 °C, more preferably between -10 °C and 10 °C; wherein the first and second compound is selected from a host material and a TADF emitter, preferably wherein at least one of the first compound and the second compound is a TADF emitter.

In a further embodiment of the invention the first compound and the second compound are TADF emitter.

In a preferred embodiment of the invention at least one of the first compound and the second compound is a host material.

In an even more preferred embodiment of the invention the first compound is a host material and the second compound is a TADF emitter.

It is an object of the present invention to provide a method of making a pre-doped organic layer which comprises the steps (I) of providing a composition of a first compound and a second compound, (II) optionally homogenizing of the composition by grinding and/or liquefying the composition by heating above the melting temperature of the first compound and the second compound depending on which compound has the higher melting point and subsequent cooling and/or dissolving the composition in a solvent or a mixture of solvents and subsequent removal of the solvent, (III) evaporation of the composition out of one material source in the vapor evaporation process and optional co-evaporation of additional compounds.

As is well known in the field of fractional distillation of two or more components of a mixture, separation of such components by sublimation (evaporation) is virtually impossible if the vapor pressure of each of the components of the mixture is identical or close.

The present invention is using a mixture of a first compound and a second compound wherein the first compound having a predetermined evaporation temperature T and the second compound having an evaporation temperature in a range of from (T-40)°C to (T+40)°C, preferably in a range of from (T-20)°C to (T+20)°C, more preferably in a range of from (T-10)°C to (T+10)°C.

Thus, the present invention also refers to a method for generating a light-emitting layer, comprising the steps:

(i) mixing a first compound and a second compound together to form a homogeneous mixture, wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure $1\times10^{-6}$ Torr to $1\times10^{-8}$ Torr; wherein the temperature difference T1-T2 is in a range between -40 °C to 40 °C, preferably between -20 °C and 20 °C, more preferably between -10 °C and 10 °C; wherein the first and second compound each is selected from a host material and a TADF emitter, preferably wherein at least one of the first compound and the second compound is a TADF emitter; and

(ii) evaporating the homogeneous mixture of the first compound and the second compound together out of one container, wherein further compounds can optionally be co-evaporated out of one or more further containers.

In other words, the present invention also refers to a method for generating a light-emitting layer, comprising the step of mixing a first compound and a second compound together to form a homogeneous mixture, wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure $1\times10^{-6}$ Torr to $1\times10^{-8}$ Torr (preferably measured at (approximately) $1\times10^{-7}$ Torr); wherein the temperature difference T1-T2 is in a range between -40 °C to 40 °C, preferably between -20 °C and 20 °C, more preferably in a range of from (T-10)°C to (T+10)°C; wherein the first and second compound is

selected from a host material and a TADF emitter, preferably wherein at least one of the first compound and the second compound is a TADF emitter; wherein the homogeneous mixture of the first compound and the second compound are evaporated together out of one container, wherein further compounds can be co-evaporated out of supplementary containers.

The step of evaporating the homogeneous mixture of the first compound and the second compound together out of one container (step (ii)) may be performed at any conditions.

In one embodiment, it is performed at a pressure range of constant pressure below $1\times10^{-5}$ Torr, preferably pressure below $1\times10^{-6}$ Torr, below $1\times10^{-7}$ Torr, or below $1\times10^{-8}$ Torr. The temperature may be adjusted to the desired deposition rate, which may be, for instance, in the range of between 0.1 and 10 Å/s (Angstom per second), between 0.5 and 5 Å/s, between 0.7 and 1 Å/s, such as (approximately) 0.8 Å/s.

In one embodiment, it is performed at a pressure range of constant pressure below $1\times10^{-5}$ Torr, preferably pressure below $1\times10^{-6}$ Torr, below $1\times10^{-7}$ Torr, or below $1\times10^{-8}$ Torr, and at temperature above the evaporation temperature of the compounds of interest such as, e.g., above 150 °C, above 200 °C, or above 300 °C.

In one embodiment, it is performed at a pressure range of constant pressure $1\times10^{-6}$ Torr to $1\times10^{-8}$ Torr and a temperature above the evaporation temperature of the compounds of interest such as, e.g., above 150 °C, above 200 °C, or above 300 °C.

The method of the present invention can also be such for generating an organic electroluminescent device. Thus, the method of the present invention my also comprise a further step (iii) of assembling an organic electroluminescent device including a light-emitting layer obtainable from step (ii). Such step (iii) may optionaly comprise co-evaporating one or more further compounds to prepare one or more further layers of the organic electroluminescent device.

Such light-emitting layer may be such according to the present invention. The method is thus also for generating an electroluminescent device.

As used throughout the present application the term mixture is understood as a combination of two different compounds, which are not chemically combined and wherein the compounds retain their chemical properties and wherein the physical properties of the combined compounds may differ from those of the compounds.

As used throughout the present application the term homogenous mixture is understood as a mixture in which the composition is uniform throughout the mixture.

In a preferred embodiment, one or more further compounds of the light-emitting layer are co-evaporated out of one or more further containers.

In a preferred embodiment the light-emission layer of the organic electroluminescent device comprises at least:

(i) the composition comprising a mixture of a first compound and a second compound; and
(ii) one further host or emitter compound.

In a more preferred embodiment the light-emission layer of the organic electroluminescent device comprises at least one small FWHM emitter.

A small full width at half maximum (FWHM) emitter in the context of the present invention is any emitter that has an emission spectrum, which exhibits an FWHM of less than or equal to 0.25 eV (≤ 0.25 eV), typically measured from a spin-coated film with 1 to 5% by weight, in particular with 2% by weight of emitter in poly(methyl methacrylate) PMMA at room temperature (i.e., (approximately) 20 °C). Alternatively, emission spectra of small FWHM emitters $S^B$ may be measured in a solution, typically with 0.001-0.2 mg/mL of the emitter $S^B$ in dichloromethane or toluene at room temperature (i.e., (approximately) 20 °C).

As known to the skilled artisan, the full width at half maximum (FWHM) of an emitter (for example a small FWHM emitter $S^B$) is readily determined from the respective emission spectrum (fluorescence spectrum for fluorescent emitters and phosphorescence spectrum for phosphorescent emitters). For small FWHM emitters $S^B$, the fluorescence spectrum is typically used. All reported, FWHM values typically refer to the main emission peak (i.e. the peak with the highest intensity). The means of determining the FWHM (herein preferably reported in electron volts, eV) are part of the common knowledge of those skilled in the art. Given for example that the main emission peak of an emission spectrum reaches its half maximum emission (i.e. 50% of the maximum emission intensity) at the two wavelengths $\lambda_1$ and $\lambda_2$, both obtained in nanometers (nm) from the emission spectrum, the FWHM in electron volts (eV) is commonly (and herein) determined using the following equation:

$$\text{FWHM [eV]} = \left| \frac{1239.84\ [eV\cdot nm]}{\lambda_2\ [nm]} - \frac{1239.84 [eV\cdot nm]}{\lambda_1\ [nm]} \right| .$$

In an even more preferred embodiment the light-emission layer of the organic electroluminescent device comprises at least:

(i) the first compound;
(ii) the second compound;
(iii) one small FWHM emitter and
(iv) a phosphorescent emitter.

In the context of the present invention, a delayed fluorescence material is a material that is capable of reaching an excited singlet state (typically the lowermost excited singlet state S1) by means of reverse intersystem crossing (RISC; in other words: up intersystem crossing or inverse intersystem crossing) from an excited triplet state (typically from the lowermost excited triplet state T1) and that is furthermore capable of emitting light when returning from the so-reached excited singlet state (typically S1) to its electronic ground state. The fluorescence emission observed after RISC from an excited triplet state (typically T1) to the emissive excited singlet state (typically S1) occurs on a timescale (typically in the range of microseconds) that is slower than the timescale on which direct (i.e. prompt) fluorescence occurs (typically in the range of nanoseconds) and is thus referred to as delayed fluorescence (DF). When RISC from an excited triplet state (typically from T1) to an excited singlet state (typically to S1), occurs through thermal activation, and if the so populated excited singlet state emits light (delayed fluorescence emission), the process is referred to as thermally activated delayed fluorescence (TADF). Accordingly, a TADF material is a material that is capable of emitting thermally activated delayed fluorescence (TADF) as explained above. It is known to the person skilled in the art that, when the energy difference $\Delta E_{ST}$ between the lowermost excited singlet state energy level E(S1) and the lowermost excited triplet state energy level E(T1) of a fluorescence emitter is reduced, population of the lowermost excited singlet state from the lowermost excited triplet state by means of RISC may occur with high efficiency. Thus, it forms part of the common knowledge of those skilled in the art that a TADF material will typically have a small $\Delta E_{ST}$ value (vide infra).

The occurrence of (thermally activated) delayed fluorescence may for example be analyzed based on the decay curve obtained from time-resolved (i.e. transient) photoluminescence (PL) measurements. PL emission from a TADF material is divided into an emission component from excited singlet states (typically S1) generated by the initial excitation and an emission component from excited states singlet (typically S1) generated via excited triplet states (typically T1) by means of RISC. There is typically a significant difference in time between emission from the singlet excited states (typically S1) formed by the initial excitation and from the singlet excited states (typically S1) reached via RISC from excited triplet states (typically T1).

TADF materials preferably fulfill the following two conditions regarding the full decay dynamics:

(i) the decay dynamics exhibit two time regimes, one typically in the nanosecond (ns) range and the other typically in the microsecond ($\mu$s) range; and
(ii) the shapes of the emission spectra in both time regimes coincide;

wherein, the fraction of light emitted in the first decay regime is taken as prompt fluorescence and the fraction emitted in the second decay regime is taken as delayed fluorescence. The PL measurements may be performed using a spin-coated film of the respective emitter (i.e. the assumed TADF material) in poly(methyl methacrylate) (PMMA) with 1-10% by weight, in particular 10% by weight of the respective emitter.

In order to evaluate whether the preferred criterion (i) is fulfilled (i.e. the decay dynamics exhibit two time regimes, one typically in the nanosecond (ns) range and the other typically in the microsecond ($\mu$s) range), *TCSPC (Time-correlated single-photon counting*) may typically be used (vide infra) and the *full decay dynamics* may typically be analyzed as stated below. Alternatively, *transient photoluminescence measurements with spectral resolution* may be performed (vide infra).

In order to evaluate whether the preferred criterion (ii) is fulfilled (i.e. the shapes of the emission spectra in both time regimes coincide), *transient photoluminescence measurements with spectral resolution* may typically be performed (vide infra).

In a preferred embodiment the TADF emitter is characterized in that:

(i) it exhibit a ΔEST value, which corresponds to the energy difference between the lowermost excited singlet state energy E(S1E) and the lowermost excited triplet state energy E(T1E), of less than 0.4 eV; and
(ii) it displays a photoluminescence quantum yield (PLQY) of more than 30%.

In a preferred embodiment of the invention the TADF compound is represented by Formula T-I,

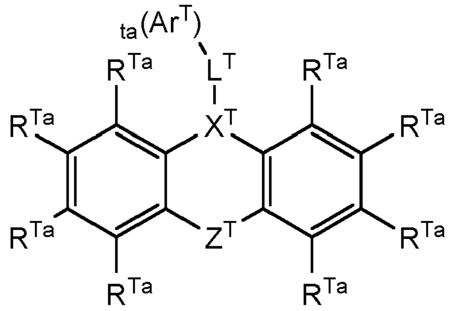

Formula T-I

wherein in Formula T-I

$X^T$ is selected from the group consisting of N and $CR^{Ta}$;
$Z^T$ is at each occurrence independently from another selected from the group consisting of: a direct bond, $CR^{Tb}R^{Tc}$, $C=CR^{Tb}R^{Tc}$, C=O, $C=NR^{Tb}$, $NR^{Tb}$, O, $SiR^{Tb}R^{Tc}$, S, S(O) and $S(O)_2$;
$L^T$ is selected from the group consisting of substituted or unsubstituted $C_6$-$C_{60}$-arylene and substituted or unsubstituted $C_3$-$C_{57}$-heteroarylene;
$Ar^T$ is selected from the group consisting of substituted or unsubstituted $C_6$-$C_{60}$-aryl and substituted or unsubstituted $C_3$-$C_{57}$-heteroaryl;
ta is an integer selected from 1 and 2;
$R^{Ta}$, $R^{Tb}$, $R^{Tc}$ are at each occurrence independently from another selected from the group consisting of: hydrogen, deuterium, $N(R^{T5})_2$, O $R^{T5}$, $Si(R^{T5})_3$, $B(OR^{T5})_2$, $OSO_2R^{T5}$, $CF_3$, CN, F, Br, I,
$C_1$-$C_{40}$-alkyl,
which is optionally substituted with one or more substituents $R^{T5}$ and
wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-alkoxy,
which is optionally substituted with one or more substituents $R^{T5}$ and
wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-thioalkoxy,
which is optionally substituted with one or more substituents $R^{F5}$ and
wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkenyl,
which is optionally substituted with one or more substituents $R^{F5}$ and
wherein one or more non-adjacent $CH_2$-groups are optionally substituted by, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkynyl,
which is optionally substituted with one or more substituents $R^{F5}$ and
wherein one or more non-adjacent $CH_2$-groups are optionally substituted by $R^{T5}C=CR^{T5}$, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_6$-$C_{60}$-aryl,
which is optionally substituted with one or more substituents $R^{T5}$;
$C_3$-$C_{57}$-heteroaryl,
which is optionally substituted with one or more substituents $R^{T5}$;
$R^{T5}$ is at each occurrence independently from another selected from the group consisting of hydrogen, deuterium, $CF_3$, CN, F, Br, I,
$C_1$-$C_{40}$-alkyl,
$C_1$-$C_{40}$-alkoxy,
$C_1$-$C_{40}$-thioalkoxy,
$C_2$-$C_{40}$-alkenyl,
$C_2$-$C_{40}$-alkynyl,
$C_6$-$C_{60}$-aryl,

$C_3$-$C_{57}$-heteroaryl;

In a still even more preferred embodiment of the invention the TADF compound comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more optionally substituted 1,3,5-triazinyl group.

The person skilled in the art knows that the expression "derivatives thereof" means that the respective parent structure may be optionally substituted or any atom within the respective parent structure may be replaced by an atom of another element for example.

In one embodiment of the invention, the TADF compound comprises

- one or more first chemical moieties, each comprising or consisting of a structure according to formula D-I:

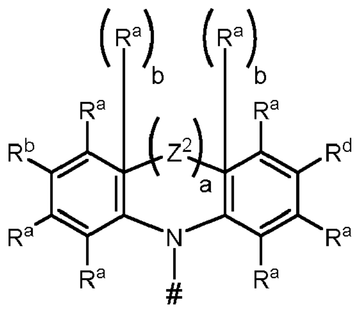

Formula D-I

and

- optionally, one or more second chemical moieties, each independently of each other selected from CN, $CF_3$, and a structure according to any of formulas A-I, A-II, A-III, and A-IV:

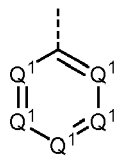 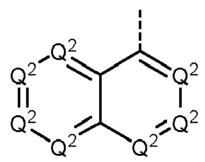 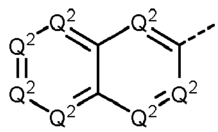 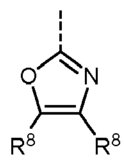 Formula

A-I Formula A-II Formula A-III Formula A-IV

and

- one third chemical moiety comprising or consisting of a structure according to any of formulas L-I, L-II, L-III, L-IV, L-V, L-VI, L-VII, and L-VIII:

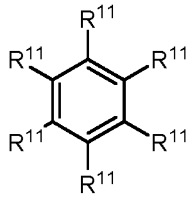

Formula L-I

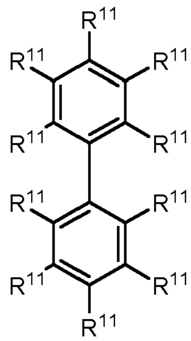

Formula L-II

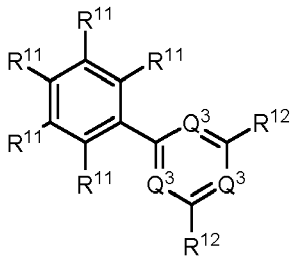

Formula L-III

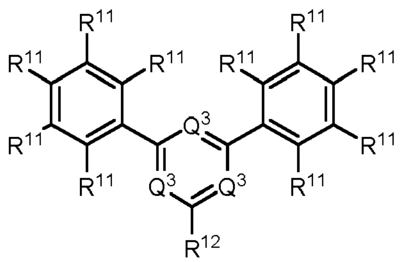

Formula L-IV

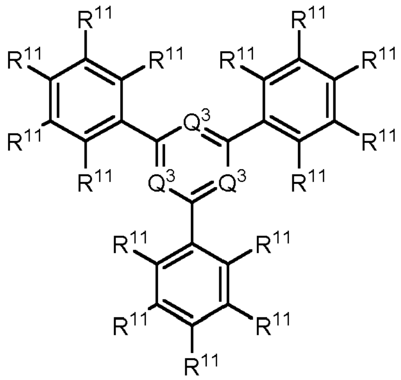

Formula L-V

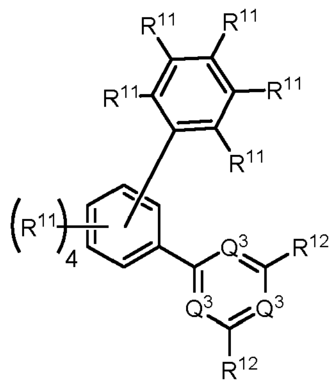

Formula L-VI

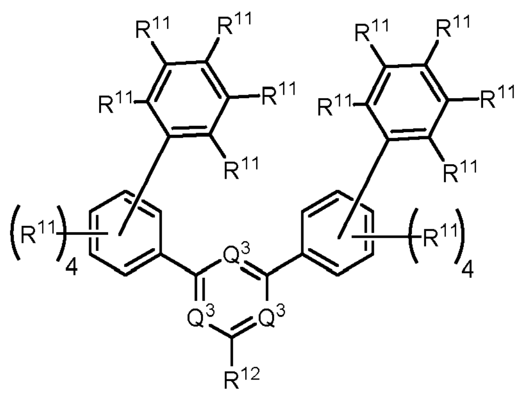

Formula L-VII

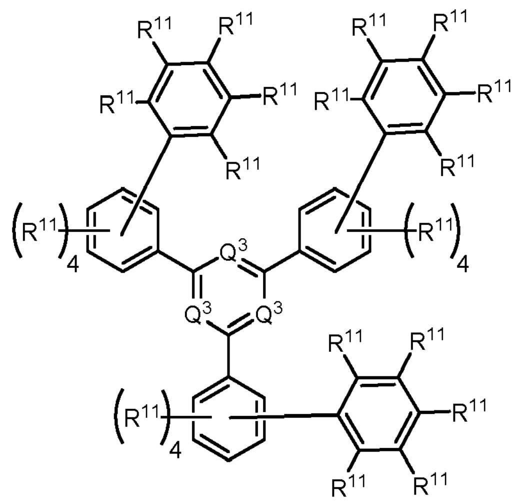

Formula L-VIII,

wherein

the one or more first chemical moieties and the optional one or more second chemical moieties are covalently bonded via a single bond to the third chemical moiety;
wherein in formula D-I:

# represents the binding site of a single bond linking the respective first chemical moiety according to formula D-I to the third chemical moiety;
$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $B(OR^3)_2$, $OSO_2R^3$, $CF_3$, CN, F, Cl, Br, I,
$C_1$-$C_{40}$-alkyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_1$-$C_{40}$-alkoxy,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_1$-$C_{40}$-thioalkoxy,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_2$-$C_{40}$-alkenyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_2$-$C_{40}$-alkynyl,
which is optionally substituted with one or more substituents $R^3$ and wherein one or more non-adjacent $CH_2$-groups are optionally substituted by $R^3C=CR^3$, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_6$-$C_{60}$-aryl,
which is optionally substituted with one or more substituents $R^3$; and
$C_3$-$C_{60}$-heteroaryl, which is optionally substituted with one or more substituents $R^3$;
$R^3$ is at each occurrence independently of each other selected from the group consisting of: hydrogen, deuterium, $N(R^4)_2$, $OR^4$, $Si(R^4)_3$, $B(OR^4)_2$, $OSO_2R^4$, $CF_3$, CN, F, Br, I,
$C_1$-$C_{40}$-alkyl,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;
$C_1$-$C_{40}$-alkoxy,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;
$C_1$-$C_{40}$-thioalkoxy,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;
$C_2$-$C_{40}$-alkenyl,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;
$C_2$-$C_{40}$-alkynyl,
which is optionally substituted with one or more substituents $R^4$ and wherein one or more non-adjacent $CH_2$-groups are optionally substituted by $R^4C=CR^4$, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;
$C_6$-$C_{60}$-aryl,

which is optionally substituted with one or more substituents $R^4$; and
$C_3$-$C_{57}$-heteroaryl,
which is optionally substituted with one or more substituents $R^4$;

wherein, optionally, any substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;
$R^4$ is at each occurrence selected from the group consisting of: hydrogen, deuterium, OPh, $CF_3$, CN, F,
$C_1$-$C_5$-alkyl,
wherein one or more hydrogen atoms are optionally, independently of each other substituted by deuterium, CN, $CF_3$, or F;
$C_1$-$C_5$-alkoxy,
wherein one or more hydrogen atoms are optionally, independently of each other substituted by deuterium, CN, $CF_3$, or F;
$C_1$-$C_5$-thioalkoxy,
wherein one or more hydrogen atoms are optionally, independently of each other substituted by deuterium, CN, $CF_3$, or F;
$C_2$-$C_5$-alkenyl,
wherein one or more hydrogen atoms are optionally, independently of each other substituted by deuterium, CN, $CF_3$, or F;
$C_2$-$C_5$-alkynyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, Ph or $C_1$-$C_5$-alkyl;
$N(C_6$-$C_{18}$-aryl$)_2$;
$N(C_3$-$C_{17}$-heteroaryl$)_2$, and
$N(C_3$-$C_{17}$-heteroaryl$)(C_6$-$C_{18}$-aryl);
a is an integer and is 0 or 1;
b is an integer and is at each occurrence 0 or 1, wherein both b are always identical;
wherein both integers b are 0 when integer a is 1 and integer a is 0 when both integers b are 1;
wherein in formulas A-I, A-II, A-III, A-IV:

the dashed line indicates a single bond linking the respective second chemical moiety according to formula A-I, A-II, A-III or A-IV to the third chemical moiety; $Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provisions that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $B(OR^9)_2$, $OSO_2R^9$, $CF_3$, CN, F, Cl, Br, I,
$C_1$-$C_{40}$-alkyl,
which is optionally substituted with one or more substituents $R^9$ and wherein one or more non-adjacent $CH_2$-groups are optionally substituted by $R^9C{=}CR^9$, C≡C, $Si(R^9)_2$, $Ge(R^9)_2$, $Sn(R^9)_2$, C=O, C=S, C=Se, $C{=}NR^9$, $P({=}O)(R^9)$, SO, $SO_2$, $NR^9$, O, S or $CONR^9$;
$C_1$-$C_{40}$-alkoxy,
which is optionally substituted with one or more substituents $R^9$ and wherein one or more non-adjacent $CH_2$-groups are optionally substituted by $R^9C{=}CR^9$, C≡C, $Si(R^9)_2$, $Ge(R^9)_2$, $Sn(R^9)_2$, C=O, C=S, C=Se, $C{=}NR^9$, $P({=}O)(R^9)$, SO, $SO_2$, $NR^9$, O, S or $CONR^9$;
$C_1$-$C_{40}$-thioalkoxy,
which is optionally substituted with one or more substituents $R^9$ and wherein one or more non-adjacent $CH_2$-groups are optionally substituted by $R^9C{=}CR^9$, C≡C, $Si(R^9)_2$, $Ge(R^9)_2$, $Sn(R^9)_2$, C=O, C=S, C=Se,

$C=NR^9$, $P(=O)(R^9)$, SO, $SO_2$, $NR^9$, O, S or $CONR^9$;
$C_2$-$C_{40}$-alkenyl,
which is optionally substituted with one or more substituents $R^9$ and wherein one or more non-adjacent $CH_2$-groups are optionally substituted by $R^9C=CR^9$, C=C, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;
$C_2$-$C_{40}$-alkynyl,
which is optionally substituted with one or more substituents $R^9$ and wherein one or more non-adjacent $CH_2$-groups are optionally substituted by $R^9C=CR^9$, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;
$C_6$-$C_{60}$-aryl,

which is optionally substituted with one or more substituents $R^9$; and $C_3$-$C_{60}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $B(OR^{10})_2$, $OSO_2R^{10}$, $CF_3$, CN, F, Cl, Br, I,
$C_1$-$C_{40}$-alkyl,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_1$-$C_{40}$-alkoxy,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_1$-$C_{40}$-thioalkoxy,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_2$-$C_{40}$-alkenyl,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_2$-$C_{40}$-alkynyl,
which is optionally substituted with one or more substituents $R^{10}$ and wherein one or more non-adjacent $CH_2$-groups are optionally substituted by $R^{10}C=CR^{10}$, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_6$-$C_{60}$-aryl,

which is optionally substituted with one or more substituents $R^{10}$; and $C_3$-$C_{60}$-heteroaryl,
which is optionally substituted with one or more substituents $R^{10}$;

$R^{10}$ is at each occurrence independently of each other selected from the group consisting of: hydrogen, deuterium, OPh, $CF_3$, CN, F,
$C_1$-$C_5$-alkyl,
wherein one or more hydrogen atoms are optionally, independently of each other substituted by deuterium, CN, $CF_3$, or F;
$C_1$-$C_5$-alkoxy,
wherein one or more hydrogen atoms are optionally, independently of each other substituted by deuterium, CN, $CF_3$, or F;
$C_1$-$C_5$-thioalkoxy,
wherein one or more hydrogen atoms are optionally, independently of each other substituted by deuterium, CN, $CF_3$, or F;
$C_2$-$C_5$-alkenyl,
wherein one or more hydrogen atoms are optionally, independently of each other substituted by deuterium, CN, $CF_3$, or F;
$C_2$-$C_5$-alkynyl,
wherein one or more hydrogen atoms are optionally, independently of each other substituted by deuterium, CN, $CF_3$, or F;

$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, Ph or $C_1$-$C_5$-alkyl;
$N(C_6$-$C_{18}$-aryl$)_2$;
$N(C_3$-$C_{17}$-heteroaryl$)_2$, and
$N(C_3$-$C_{17}$-heteroaryl$)(C_6$-$C_{18}$-aryl$)$;
$R^7$ is at each occurrence independently of each other selected from the group consisting of CN, $CF_3$ and a structure according to formula EWG-I:

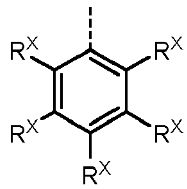

Formula EWG-I,

wherein $R^X$ is defined as $R^6$, with the provision that at least one group $R^X$ in formula EWG-I is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;
wherein in formulas L-I, L-II, L-III, L-IV, L-V, L-VI, L-VII, and L-VIII:
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, F, Cl, Br, I,
$C_1$-$C_5$-alkyl,

wherein one or more hydrogen atoms are optionally substituted by deuterium; $C_6$-$C_{18}$-aryl,
wherein one or more hydrogen atoms are optionally, independently of each other substituted by deuterium, $C_1$-$C_5$-alkyl groups, $C_6$-$C_{18}$-aryl groups, F, Cl, Br, and I;

$R^{12}$ is defined as $R^6$.

In a preferred embodiment of the invention,

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,
$C_1$-$C_{40}$-alkyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_6$-$C_{60}$-aryl,

which is optionally substituted with one or more substituents $R^3$; and $C_3$-$C_{60}$-heteroaryl,
which is optionally substituted with one or more substituents $R^3$;

$R^3$ is at each occurrence independently of each other selected from the group consisting of: hydrogen, deuterium, $N(R^4)_2$, $OR^4$, $Si(R^4)_3$, $CF_3$, CN, F, Br, I, $C_1$-$C_{40}$-alkyl,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, $P(=O)(R^4)$, SO,

$SO_2$, $NR^4$, O, S or $CONR^4$;
$C_6$-$C_{60}$-aryl,
which is optionally substituted with one or more substituents $R^4$; and
$C_3$-$C_{57}$-heteroaryl,
which is optionally substituted with one or more substituents $R^4$;
wherein, optionally, any of the substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;
$R^4$ is at each occurrence independently of each other selected from the group consisting of: hydrogen, deuterium, $CF_3$, CN, F,
$C_1$-$C_5$-alkyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN; $C_3$-$C_{17}$-heteroaryl,
wherein one or more hydrogen atoms are optionally, independently of each other substituted by deuterium, $C_1$-$C_5$-alkyl or Ph;
$N(C_6\text{-}C_{18}\text{-aryl})_2$;
$N(C_3\text{-}C_{17}\text{-heteroaryl})_2$, and
$N(C_3\text{-}C_{17}\text{-heteroaryl})(C_6\text{-}C_{18}\text{-aryl})$;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, Cl, Br, I,
$C_1$-$C_{40}$-alkyl,
which is optionally substituted with one or more substituents $R^9$ and wherein one or more non-adjacent $CH_2$-groups are optionally substituted by $R^9C{=}CR^9$, C=C, $Si(R^9)_2$, $Ge(R^9)_2$, $Sn(R^9)_2$, C=O, C=S, C=Se, $C{=}NR^9$, $P({=}O)(R^9)$, SO, $SO_2$, $NR^9$, O, S or $CONR^9$;
$C_6$-$C_{60}$-aryl,

which is optionally substituted with one or more substituents $R^9$; and $C_3$-$C_{60}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $CF_3$, CN, F, Cl, Br, I, $C_1$-$C_{40}$-alkyl,
which is optionally substituted with one or more substituents $R^{10}$ and wherein one or more non-adjacent $CH_2$-groups are optionally substituted by $R^{10}C{=}CR^{10}$, C≡C, $Si(R^{10})_2$, $Ge(R^{10})_2$, $Sn(R^{10})_2$, C=O, C=S, C=Se, $C{=}NR^{10}$, $P({=}O)(R^{10})$, SO, $SO_2$, $NR^{10}$, O, S or $CONR^{10}$;
$C_6$-$C_{60}$-aryl,

which is optionally substituted with one or more substituents $R^{10}$; and $C_3$-$C_{60}$-heteroaryl,
which is optionally substituted with one or more substituents $R^{10}$;

$R^{10}$ is at each occurrence independently of each other selected from the group consisting of: hydrogen, deuterium, OPh, $CF_3$, CN, F,
$C_1$-$C_5$-alkyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium,

$C_1$-$C_5$-alkyl, Ph or CN;
$C_3$-$C_{17}$-heteroaryl,
wherein one or more hydrogen atoms are optionally, independently of each other substituted by deuterium, $C_1$-$C_5$-alkyl or Ph;
$N(C_6$-$C_{18}$-aryl$)_2$;
$N(C_3$-$C_{17}$-heteroaryl$)_2$, and
$N(C_3$-$C_{17}$-heteroaryl$)(C_6$-$C_{18}$-aryl);
$R^7$ is at each occurrence independently of each other selected from the group consisting of CN, $CF_3$ and a structure according to formula EWG-I:

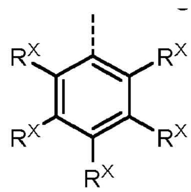

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV and optionally substituted with one or more substituents $R^{10}$; wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium,
$C_1$-$C_5$-alkyl,

wherein one or more hydrogen atoms are optionally substituted by deuterium; $C_6$-$C_{18}$-aryl,
wherein one or more hydrogen atoms are optionally, independently of each other substituted by deuterium, $C_1$-$C_5$-alkyl groups, and $C_6$-$C_{18}$-aryl groups; $R^{12}$ is defined as $R^6$;

wherein the maximum number of first and second chemical moieties attached to the third chemical moiety is only limited by the number of available binding sites on the third chemical moiety (in other words: the number of substituents $R^{11}$), with the aforementioned provision, that each TADF material $E^B$ comprises at least one first chemical moiety, at least one second chemical moiety, and exactly one third chemical moiety.

In an even more preferred embodiment of the invention,

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,
$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;
$R^3$ is at each occurrence independently of each other selected from the group consisting of: hydrogen, deuterium, $N(R^4)_2$, $Si(R^4)_3$, $CF_3$, CN, F,
$C_1$-$C_5$-alkyl,

which is optionally substituted with one or more substituents $R^4$ and $C_6$-$C_{18}$-aryl,
which is optionally substituted with one or more substituents $R^4$; and $C_3$-$C_{17}$-heteroaryl,

which is optionally substituted with one or more substituents $R^4$;
wherein, optionally, any of the substituents $R^a$, $R^b$, $R^d$, $R^1$, $R^2$ and $R^3$ independently of each other form a mono- or polycyclic, aliphatic or aromatic, carbo- or heterocyclic ring system with one or more adjacent substituents selected from $R^a$, $R^b$, $R^d$, $R^1$, $R^2$, and $R^3$; wherein the optionally so formed ring system may optionally be substituted with one or more substituents $R^5$;

$R^4$ and $R^5$ are at each occurrence independently of each other selected from the group consisting of: hydrogen, deuterium, $CF_3$, CN, F, Me, $^i$Pr, $^t$Bu, $N(Ph)_2$, and Ph, wherein one or more hydrogen atoms are optionally, independently of each other substituted by deuterium, Me, $^i$Pr, $^t$Bu, and Ph;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, $C_1$-$C_5$-alkyl,

which is optionally substituted with one or more substituents $R^9$; $C_6$-$C_{18}$-aryl,
which is optionally substituted with one or more substituents $R^9$; and $C_3$-$C_{17}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $CF_3$, CN, F, $C_1$-$C_5$-alkyl,

which is optionally substituted with one or more substituents $R^{10}$ $C_6$-$C_{18}$-aryl,
which is optionally substituted with one or more substituents $R^{10}$; and $C_3$-$C_{17}$-heteroaryl,
which is optionally substituted with one or more substituents $R^{10}$;

$R^{10}$ is at each occurrence independently of each other selected from the group consisting of: hydrogen, deuterium, Me, $^i$Pr, $^t$Bu, $CF_3$, CN, F, $N(Ph)_2$, and Ph, wherein one or more hydrogen atoms are optionally, independently of each other substituted by deuterium, Me, $^i$Pr, $^t$Bu, Ph, CN, $CF_3$, or F;
$R^7$ is at each occurrence independently of each other selected from the group consisting of CN, $CF_3$ and a structure according to formula EWG-I:

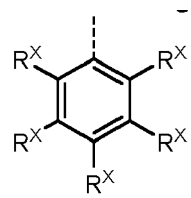

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium,
$C_1$-$C_5$-alkyl,

wherein one or more hydrogen atoms are optionally substituted by deuterium; $C_6$-$C_{18}$-aryl, which is optionally substituted with one or more substituents independently of each other selected from the group consisting of: deuterium, Me, $^iPr$, $^tBu$, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, $C_1$-$C_5$-alkyl,

which is optionally substituted with one or more substituents $R^3$ $C_6$-$C_{18}$-aryl, which is optionally substituted with one or more substituents $R^3$; and $C_3$-$C_{17}$-heteroaryl, which is optionally substituted with one or more substituents $R^3$;

$R^3$ is at each occurrence independently of each other selected from the group consisting of: hydrogen, deuterium, $CF_3$, CN, F, Me, $^iPr$, $^tBu$, $N(Ph)_2$,
Ph, wherein one or more hydrogen atoms are optionally, independently of each other substituted by deuterium, Me, $^iPr$, $^tBu$, and Ph;
wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D-1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, $C_1$-$C_5$-alkyl,

which is optionally substituted with one or more substituents $R^9$; $C_6$-$C_{18}$-aryl, which is optionally substituted with one or more substituents $R^9$; and $C_3$-$C_{17}$-heteroaryl, which is optionally substituted with one or more substituents $R^9$;

$R^9$ is at each occurrence independently of each other selected from the group consisting of: hydrogen, deuterium, Me, $^iPr$, $^tBu$, $CF_3$, CN, F, $N(Ph)_2$, and Ph, wherein one or more hydrogen atoms are optionally, independently of each other substituted by deuterium, Me, $^iPr$, $^tBu$, Ph, CN, $CF_3$, or F.
$R^7$ is at each occurrence independently of each other selected from the group consisting of CN, $CF_3$ and a structure according to formula EWG-I:

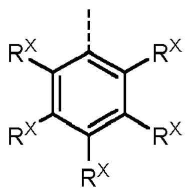

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and
Ph, which is optionally substituted with one or more substituents independently of each other selected from the group consisting of: deuterium, Me, $^i$Pr, $^t$Bu, and Ph;
$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^i$Pr, $^t$Bu,
Ph, wherein one or more hydrogen atoms are optionally, independently of each other substituted by deuterium, Me, $^i$Pr, $^t$Bu, and Ph;
carbazolyl, wherein one or more hydrogen atoms are optionally, independently of each other substituted by deuterium, Me, $^i$Pr, $^t$Bu, and Ph;
triazinyl, wherein one or more hydrogen atoms are optionally, independently of each other substituted by deuterium, Me, $^i$Pr, $^t$Bu, and Ph;
pyrimidinyl, wherein one or more hydrogen atoms are optionally, independently of each other substituted by deuterium, Me, $^i$Pr, $^t$Bu, and Ph;
pyridinyl, wherein one or more hydrogen atoms are optionally, independently of each other substituted by deuterium, Me, $^i$Pr, $^t$Bu, and Ph;
$R^1$ and $R^2$ are at each occurrence independently of each other selected from the group consisting of: hydrogen, deuterium, $N(R^3)_2$, $OR^3$, $Si(R^3)_3$, $CF_3$, CN, $C_1$-$C_5$-alkyl,

which is optionally substituted with one or more substituents $R^3$ $C_6$-$C_{18}$-aryl,
which is optionally substituted with one or more substituents $R^3$; and $C_3$-$C_{17}$-heteroaryl,
which is optionally substituted with one or more substituents $R^3$;

$R^3$ is at each occurrence independently of each other selected from the group consisting of: hydrogen, deuterium, $CF_3$, CN, F, Me, $^i$Pr, $^t$Bu, and Ph, wherein one or more hydrogen atoms are optionally, independently of each other substituted by deuterium, Me, $^i$Pr, $^t$Bu, and Ph;
wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, $C_1$-$C_5$-alkyl,

which is optionally substituted with one or more substituents $R^9$; $C_6$-$C_{18}$-aryl,
which is optionally substituted with one or more substituents $R^9$; and $C_3$-$C_{17}$-heteroaryl,
which is optionally substituted with one or more substituents $R^9$;

$R^9$ is at each occurrence independently of each other selected from the group consisting of: hydrogen, deuterium, Me, $^i$Pr, $^t$Bu, $CF_3$, CN, F, $N(Ph)_2$, and Ph, wherein one or more hydrogen atoms are optionally, independently of each other substituted by deuterium, Me, $^i$Pr, $^t$Bu, Ph, CN, $CF_3$, or F;
$R^7$ is at each occurrence independently of each other selected from the group consisting of CN, $CF_3$ and a structure according to formula EWG-I:

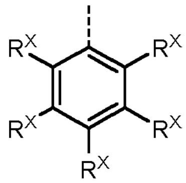

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and
Ph, which is optionally substituted with one or more substituents independently of each other selected from the group consisting of: deuterium, Me, $^i$Pr, $^t$Bu, and Ph;
$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^i$Pr, $^t$Bu,
Ph, wherein one or more hydrogen atoms are optionally, independently of each
other substituted by deuterium, Me, $^i$Pr, $^t$Bu, and Ph; and carbazolyl, wherein one or more hydrogen atoms are optionally, independently of
each other substituted by deuterium, Me, $^i$Pr, $^t$Bu, and Ph;
$R^1$ and $R^2$ are at each occurrence independently of each other selected from the group consisting of: hydrogen, deuterium, $OR^3$, $Si(R^3)_3$,
$C_1$-$C_5$-alkyl,
which is optionally substituted with one or more substituents $R^3$
$C_6$-$C_{18}$-aryl,
which is optionally substituted with one or more substituents $R^3$; and
$R^3$ is at each occurrence independently of each other selected from the group consisting of: hydrogen, deuterium, $CF_3$, CN, F, Me, $^i$Pr, $^t$Bu, and Ph, wherein one or more hydrogen atoms are optionally, independently of each other substituted by deuterium, Me, $^i$Pr, $^t$Bu, and Ph;
wherein, optionally, any of the substituents $R^a$, $R^b$, $R^d$, $R^1$, and $R^2$ independently of each other form a mono- or polycyclic, aliphatic or aromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that

in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, OPh, $N(Ph)_2$, $Si(Me)_3$, $Si(Ph)_3$, $CF_3$, CN, F, Me, $^iPr$, $^tBu$,

Ph, wherein one or more hydrogen atoms are optionally, independently of each other substituted by deuterium, Me, $^iPr$, $^tBu$, and Ph;

carbazolyl, wherein one or more hydrogen atoms are optionally, independently of each other substituted by deuterium, Me, $^iPr$, $^tBu$, and Ph;

$R^7$ is at each occurrence independently of each other selected from the group consisting of CN, $CF_3$ and a structure according to formula EWG-I:

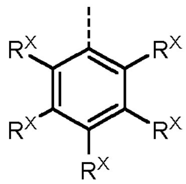

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^iPr$, $^tBu$, and

Ph, which is optionally substituted with one or more substituents independently of each other selected from the group consisting of: deuterium, Me, $^iPr$, $^tBu$, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $N(Ph)_2$, $Si(Me)_3$, $Si(Ph)_3$, $CF_3$, CN, Me, $^iPr$, $^tBu$,

Ph, wherein one or more hydrogen atoms are optionally, independently of each other substituted by deuterium, Me, $^iPr$, $^tBu$, and Ph; and carbazolyl, wherein one or more hydrogen atoms are optionally, independently of each other substituted by deuterium, Me, $^iPr$, $^tBu$, and Ph;

$R^1$ and $R^2$ are at each occurrence independently of each other selected from the group consisting of: hydrogen, deuterium, Me, $^iPr$, $^tBu$,

Ph, wherein one or more hydrogen atoms are optionally, independently of each other substituted by deuterium, Me, $^iPr$, $^tBu$, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more substituents selected from $R^a$, $R^b$, $R^d$, $R^1$, and $R^2$; wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical; wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that

in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(Ph)_2$, $Si(Me)_3$, $Si(Ph)_3$, Me, $^iPr$, $^tBu$, Ph, wherein one or more hydrogen atoms are optionally, independently of each
other substituted by deuterium, Me, $^iPr$, $^tBu$, and Ph; carbazolyl, wherein one or more hydrogen atoms are optionally, independently of
each other substituted by deuterium, Me, $^iPr$, $^tBu$, and Ph;
$R^7$ is at each occurrence independently of each other selected from the group consisting of CN, $CF_3$ and a structure according to formula EWG-I:

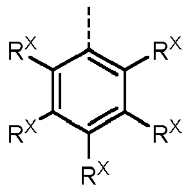

Formula EWG-I,

wherein $R^X$ is defined as $R^6$, but may also be CN or $CF_3$, with the provision, that at least one group $R^X$ is CN or $CF_3$; wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, Me, $^iPr$, $^tBu$, and
Ph, which is optionally substituted with one or more substituents independently of each other selected from the group consisting of: deuterium, Me, $^iPr$, $^tBu$, and Ph;
$R^{12}$ is defined as $R^6$.

In a particularly preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, and $R^d$ are at each occurrence independently of each other selected from the group consisting of: hydrogen, deuterium, $CF_3$, CN, Me, $^iPr$, $^tBu$, and Ph, wherein one or more hydrogen atoms are optionally, independently of each other substituted by deuterium, Me, $^iPr$, $^tBu$, and Ph;
$R^1$ and $R^2$ are at each occurrence independently of each other selected from the group consisting of: hydrogen, deuterium, Me, $^iPr$, $^tBu$, and
Ph, wherein one or more hydrogen atoms are optionally, independently of each
other substituted by deuterium, Me, $^iPr$, $^tBu$, and Ph;
wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen,

deuterium, $N(Ph)_2$, Me, $^{i}Pr$, $^{t}Bu$,

Ph, wherein one or more hydrogen atoms are optionally, independently of each

other substituted by deuterium, Me, $^{i}Pr$, $^{t}Bu$, and Ph; and carbazolyl, wherein one or more hydrogen atoms are optionally, independently of

each other substituted by deuterium, Me, $^{i}Pr$, $^{t}Bu$, and Ph;

$R^7$ is at each occurrence independently of each other selected from the group consisting of CN, $CF_3$ and a structure according to formula EWG-I:

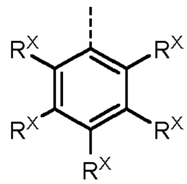

Formula EWG-I,

wherein $R^X$ is defined as $R^6$, but may also be CN or $CF_3$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^{i}Pr$, $^{t}Bu$, and

Ph, which is optionally substituted with one or more substituents independently of each other selected from the group consisting of: deuterium, Me, $^{i}Pr$, $^{t}Bu$, and Ph;

$R^{12}$ is defined as $R^6$.

In a preferred embodiment of the invention, a is always 1 and b is always 0.

In a preferred embodiment of the invention, $Z^2$ is at each occurrence a direct bond.

In a preferred embodiment of the invention, $R^a$ is at each occurrence hydrogen.

In a preferred embodiment of the invention, $R^a$ and $R^d$ are at each occurrence hydrogen.

In a preferred embodiment of the invention, $Q^3$ is at each occurrence nitrogen (N).

In one embodiment of the invention, at least one group $R^X$ in formula EWG-I is CN.

In a preferred embodiment of the invention, exactly one group $R^X$ in formula EWG-I is CN.

In a preferred embodiment of the invention, exactly one group $R^X$ in formula EWG-I is CN and no group $R^X$ in formula EWG-I is $CF_3$.

Examples of first chemical moieties according to the present invention are shown below, which does of course not imply that the present invention is limited to these examples:

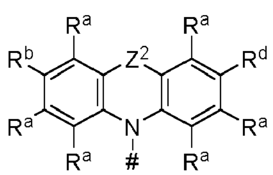
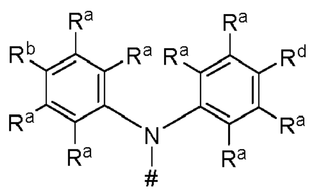
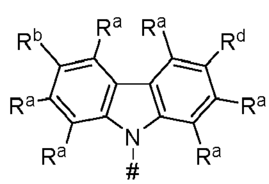

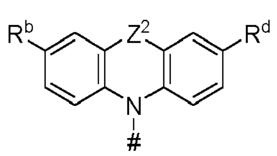
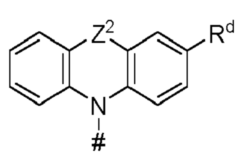
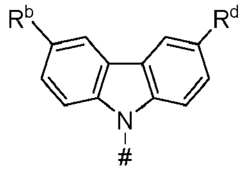
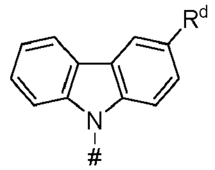

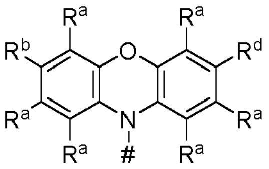
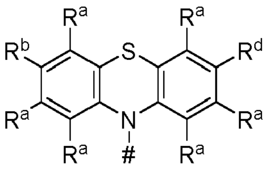
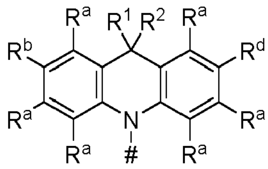
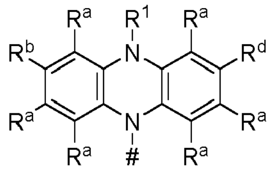

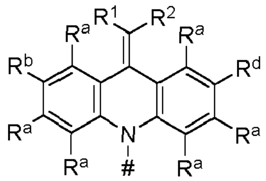
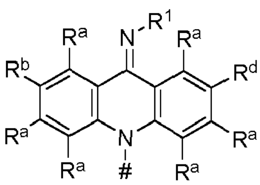
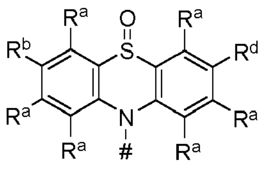
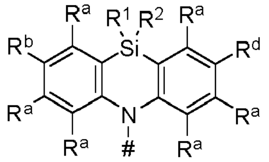

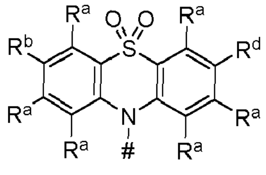
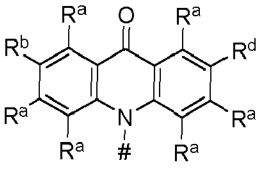
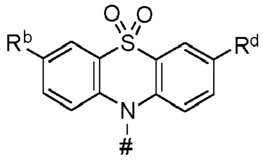
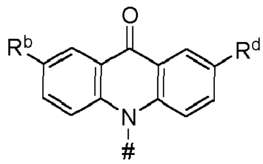

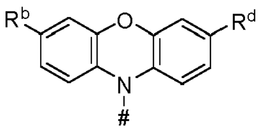
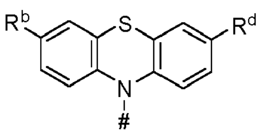
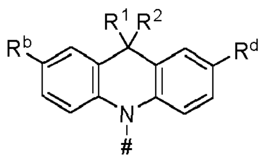
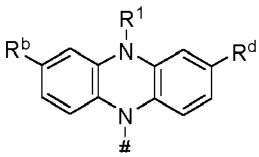

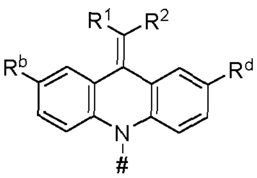
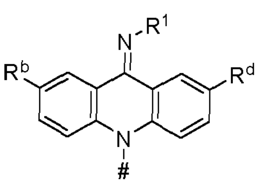
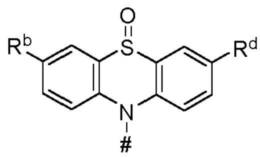
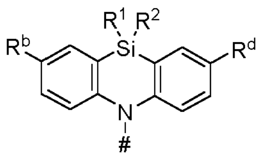

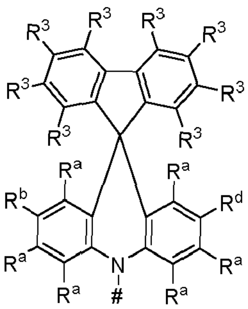
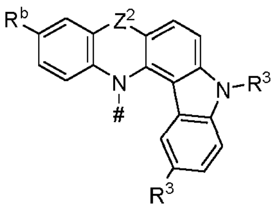
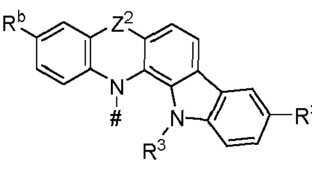
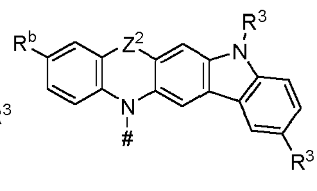

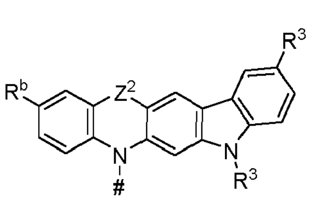
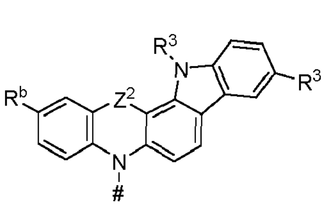
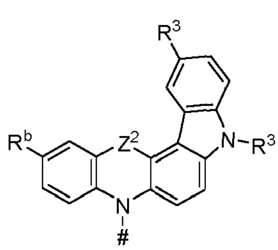

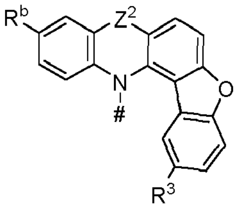
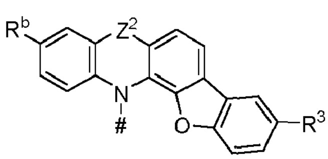
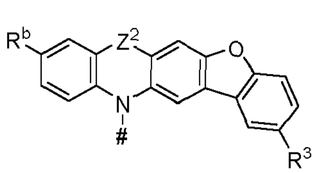

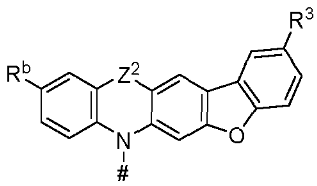

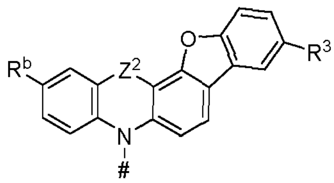

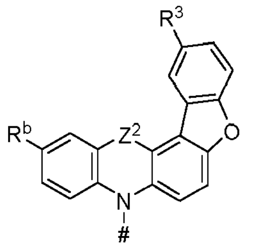

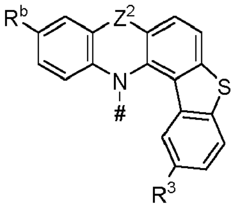

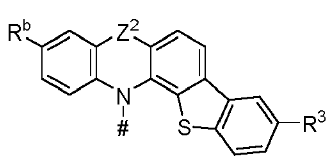

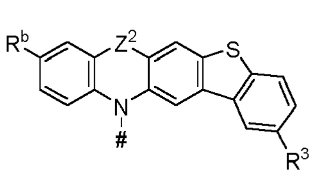

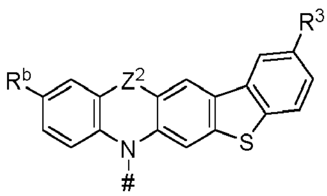

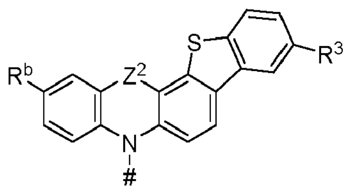

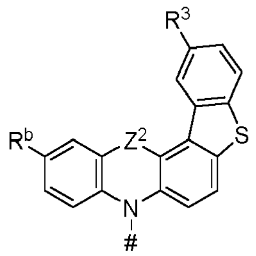

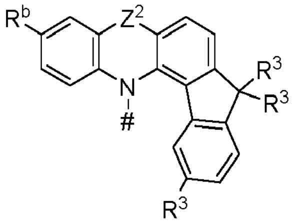

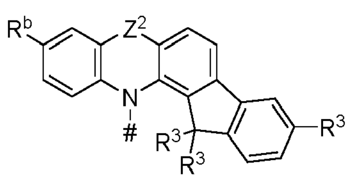

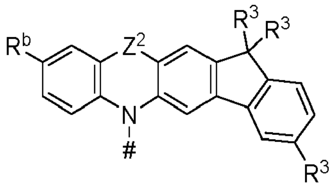

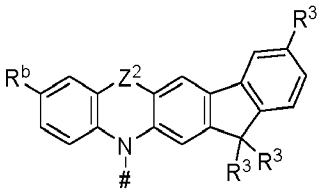

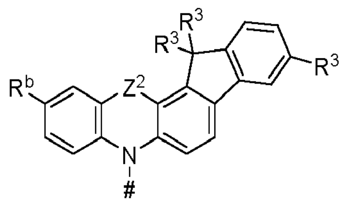

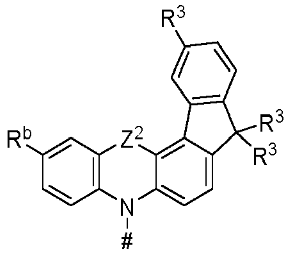

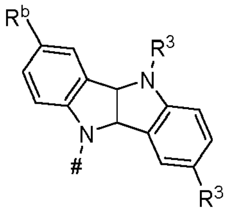

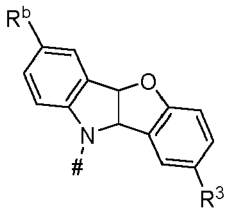

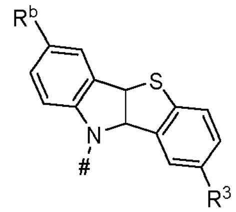

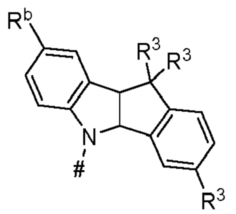

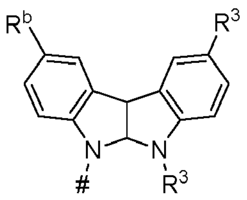 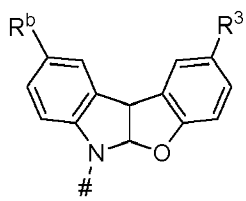 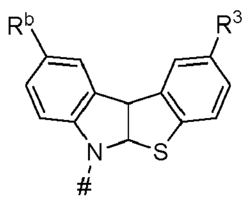 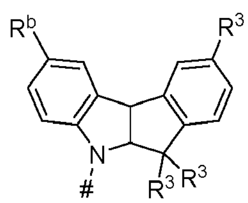

, wherein the aforementioned definitions apply.

Examples of second chemical moieties according to the present invention are shown below, which does of course not imply that the present invention is limited to these examples:

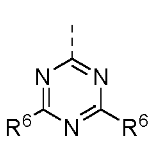 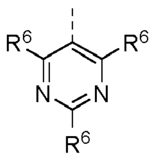 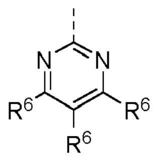 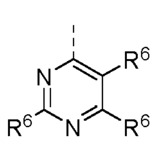 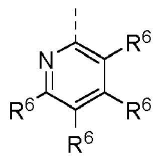 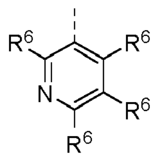

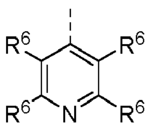 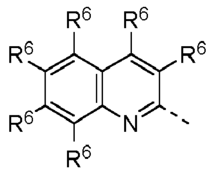 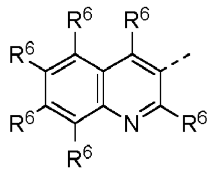 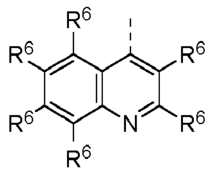

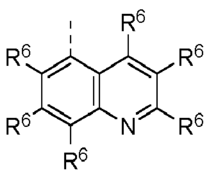 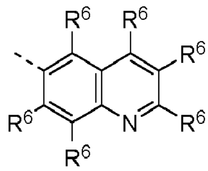 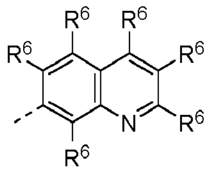 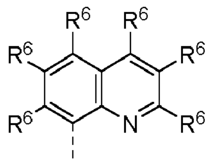

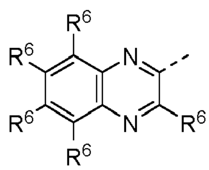 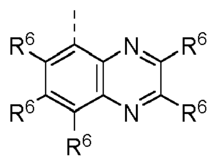 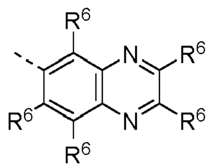 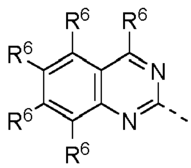

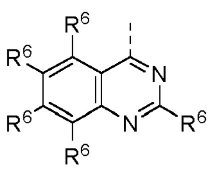 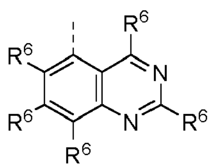 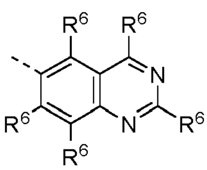 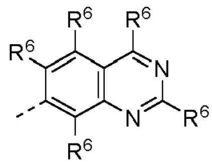

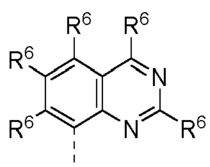 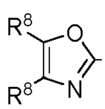 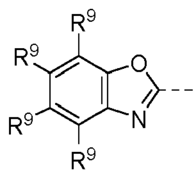 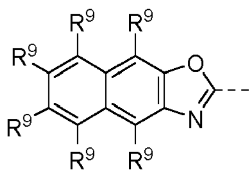 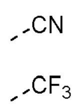

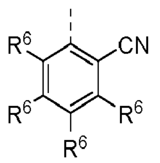 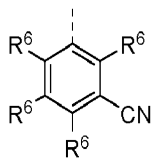 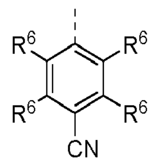 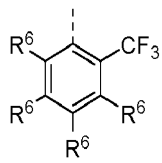 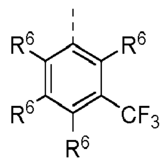 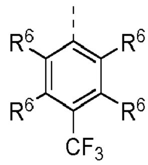

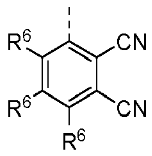 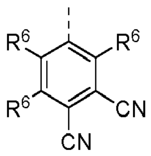 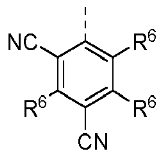 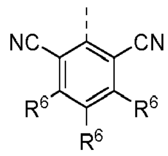 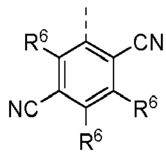 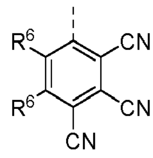

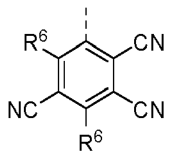 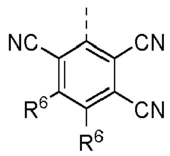 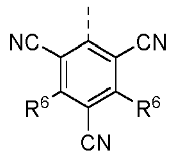 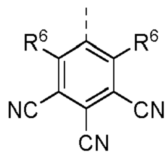 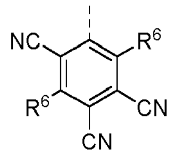 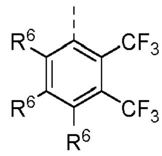

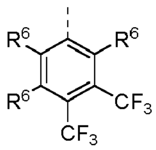 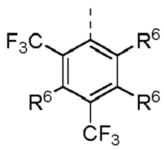 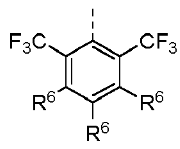 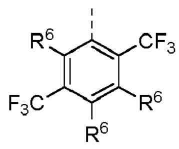 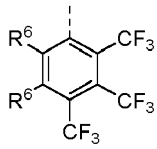 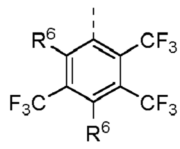

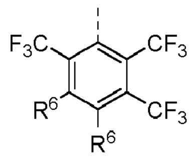 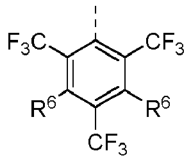 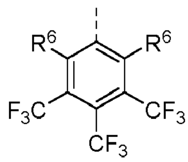 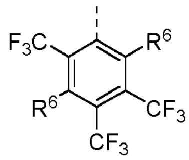 ,

wherein the aforementioned definitions apply.

In a preferred embodiment of the invention the TADF compound has a structure represented by any of formulas $E^B$-I, $E^B$-II, $E^B$-III, $E^B$-IV, $E^B$-V, $E^B$-VI, $E^B$-VII, $E^B$-VIII, and $E^B$-IX, $E^B$-X, and $E^B$-XI:

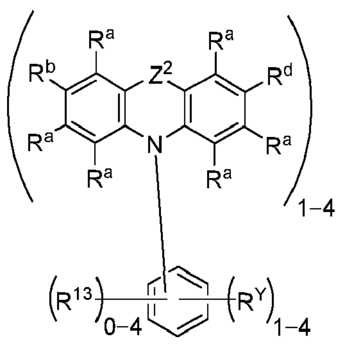

Formula $E^B$-I

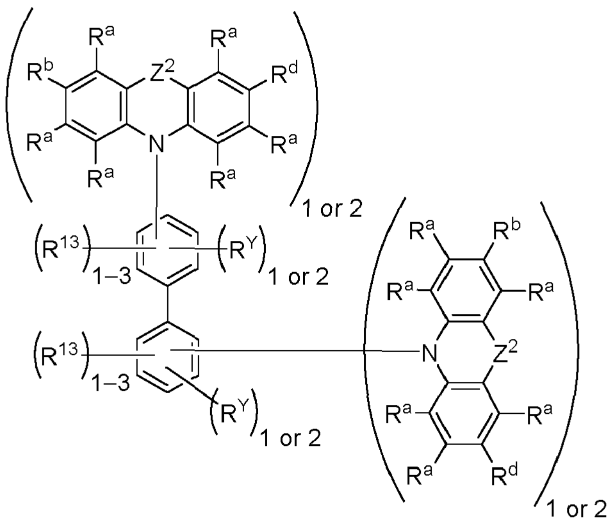

Formula $E^B$-II

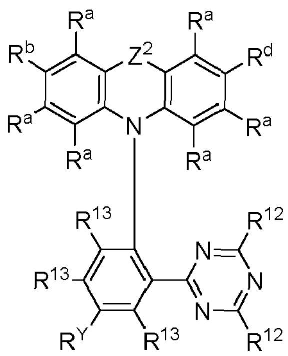

Formula $E^B$-III

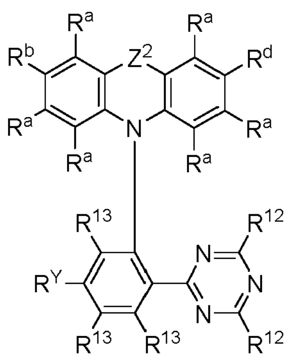

Formula $E^B$-IV

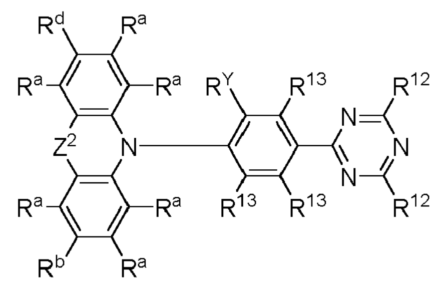

Formula $E^B$-V

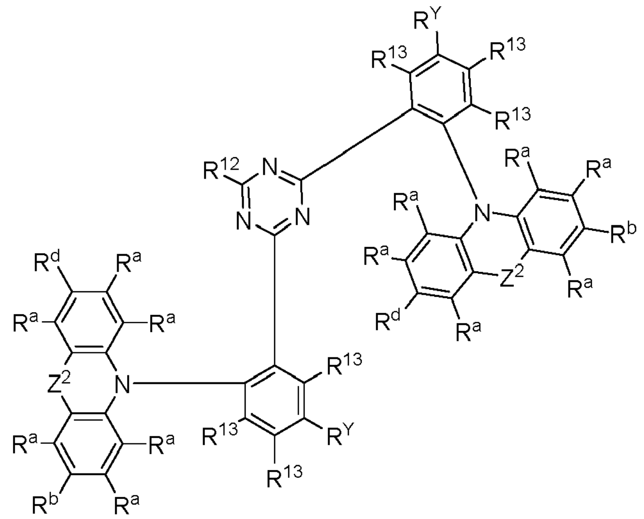

Formula $E^B$-VI

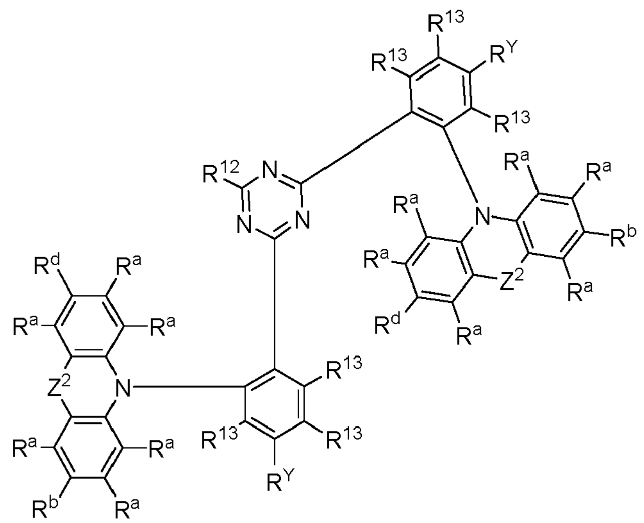

Formula $E^B$-VII

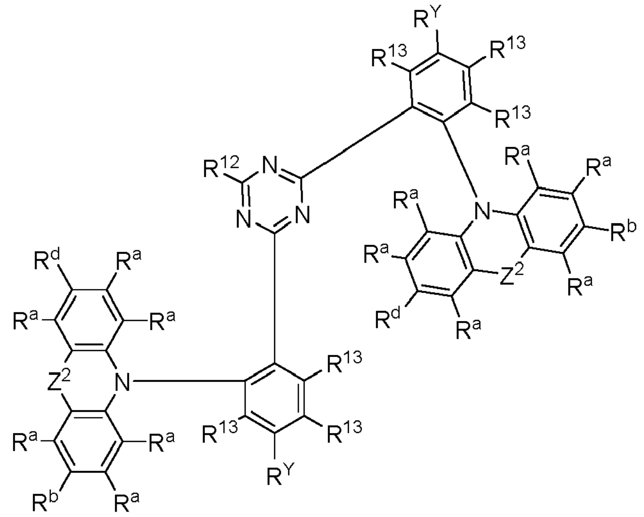

Formula $E^B$-VIII

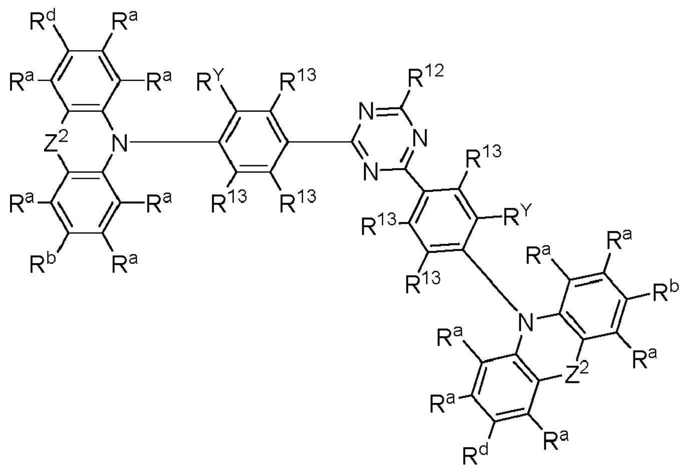

Formula $E^B$-IX,

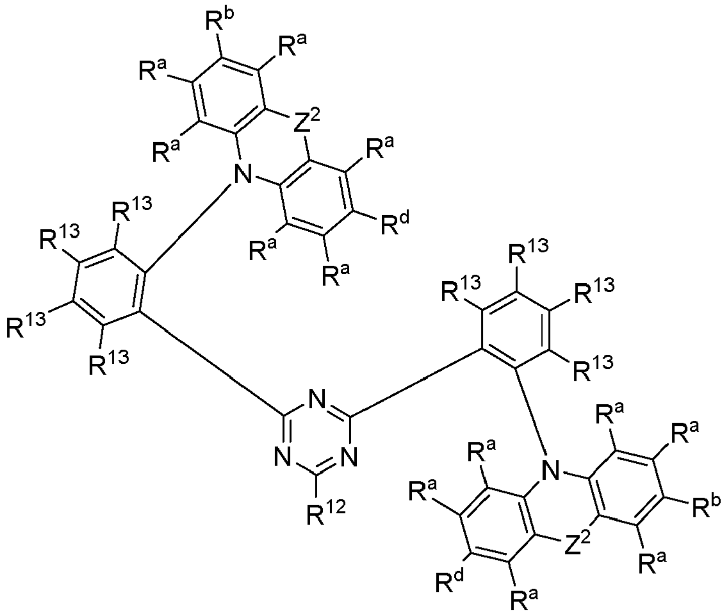

Formula $E^B$-X

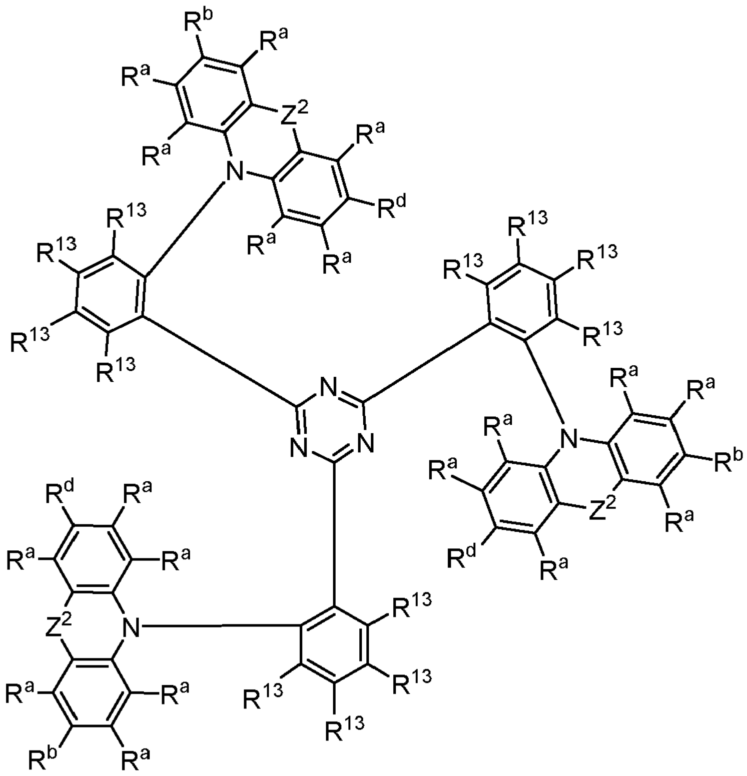

Formula $E^B$-XI

wherein

$R^{13}$ is defined as $R^{11}$ with the provision that $R^{13}$ cannot be a binding site of a single bond connecting a first or a second chemical moiety to the third chemical moiety; $R^Y$ is selected from CN and $CF_3$ or $R^Y$ comprises or consists of a structure according to formula BN-I:

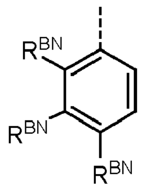

Formula BN-I,

which is bonded to the structure of formula $E^B$-I, $E^B$-II, $E^B$-III, $E^B$-IV, $E^B$-V, $E^B$-VI, $E^B$-VII, $E^B$-VIII or $E^B$-IX via a single bond indicated by the dashed line and wherein exactly one $R^{BN}$ group is CN while the other two $R^{BN}$ groups are both hydrogen (H); and wherein apart from that the above-mentioned definitions apply.

In a preferred embodiment of the invention, $R^{13}$ is at each occurrence hydrogen.

In one embodiment of the invention, $R^Y$ is at each occurrence CN.

In one embodiment of the invention, $R^Y$ is at each occurrence $CF_3$.

In one embodiment of the invention, $R^Y$ is at each occurrence a structure represented by formula BN-I.

In a preferred embodiment of the invention, $R^Y$ is at each occurrence independently of each other selected from CN and a structure represented by formula BN-I.

In a preferred embodiment of the invention, each TADF material $E^B$ has a structure represented by any of formulas $E^B$-I, $E^B$-II, $E^B$-III, $E^B$-IV, $E^B$-V, $E^B$-VI, $E^B$-VII, and $E^B$-X, wherein the aforementioned definitions apply.

In a preferred embodiment of the invention, each TADF material $E^B$ has a structure represented by any of formulas $E^B$-I, $E^B$-II, $E^B$-III, $E^B$-V, and $E^B$-X, wherein the aforementioned definitions apply.

In an embodiment of the invention the host compound comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^p$-X:

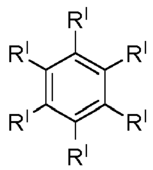

Formula $H^P$-I

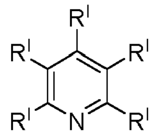

Formula $H^P$-II

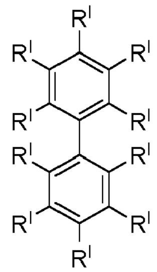

Formula $H^P$-III

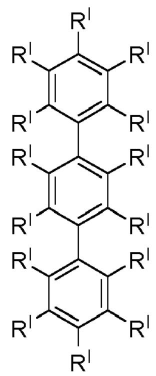

Formula $H^P$-IV

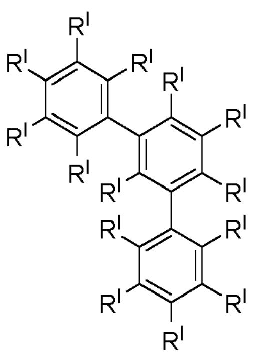

Formula $H^P$-V

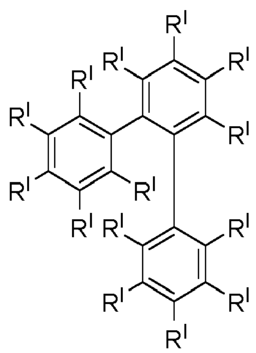

Formula $H^P$-VI

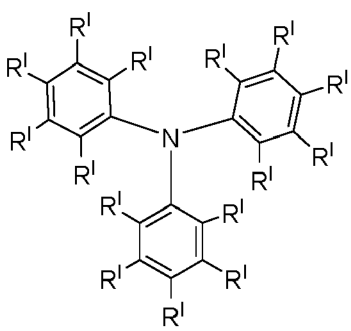

Formula $H^P$-VII

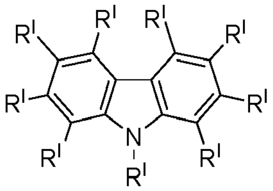

Formula $H^P$-VIII

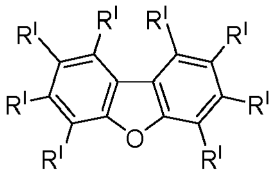

Formula $H^P$-IX

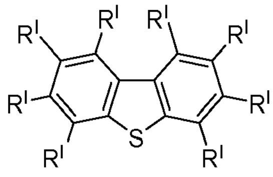

Formula $H^P$-X

and

- one or more second chemical moieties, each comprising or consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

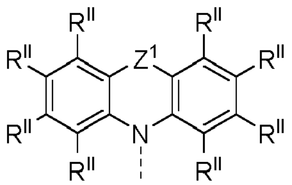

Formula $H^P$-XI

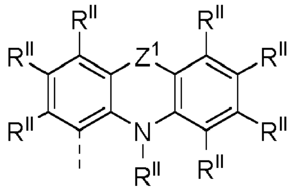

Formula $H^P$-XII

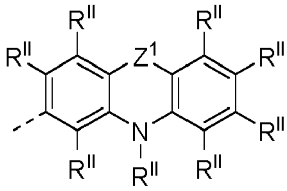

Formula $H^P$-XIII

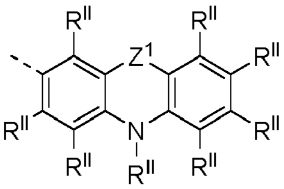

Formula $H^P$-XIV

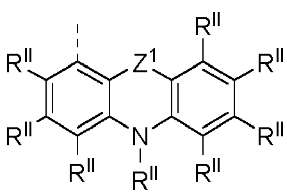

Formula $H^P$-XV

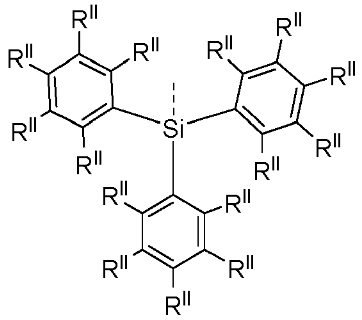

Formula $H^P$-XVI

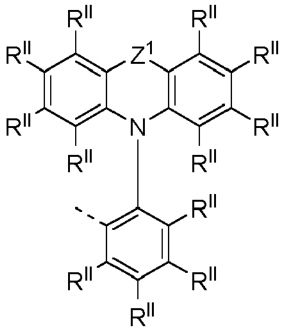

Formula $H^P$-XVII

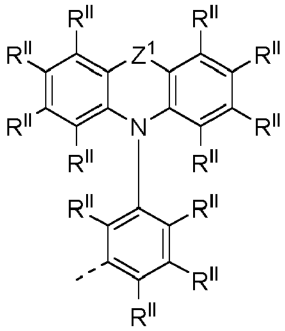

Formula $H^P$-XVIII

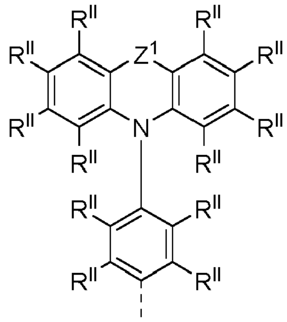

Formula $H^P$-XIX,

wherein each of the one or more second chemical moieties which is present in the host, in particular a p-host material $H^P$, is linked to the first chemical moiety via a single bond which is represented in the formulas above by a dashed line; wherein

$Z^1$ is at each occurrence independently of each other selected from the group consisting of a direct bond, $C(R^{II})_2$, $C{=}C(R^{II})_2$, C=O, $C{=}NR^{II}$, $NR^{II}$, O, $Si(R^{II})_2$, S, S(O) and $S(O)_2$;

$R^I$ is at each occurrence independently of each other a binding site of a single bond linking the first chemical moiety to a second chemical moiety or is selected from the group consisting of: hydrogen, deuterium, Me, $^iPr$, and $^tBu$, and

Ph, which is optionally substituted with one or more substituents independently of each other selected from the group consisting of: Me, $^iPr$, $^tBu$, and Ph;

wherein at least one $R^I$ is a binding site of a single bond linking the first chemical moiety to a second chemical moiety;

$R^{II}$ is at each occurrence independently of each other selected from the group consisting of: hydrogen, deuterium, Me, $^iPr$, $^tBu$, and

Ph, which is optionally substituted with one or more substituents independently of each other selected from the group consisting of: Me, $^iPr$, $^tBu$, and Ph; wherein two or more adjacent substituents $R^{II}$ may optionally form a mono- or polycyclic, aliphatic or aromatic or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents $R^{II}$ comprises in total 8-60 carbon atoms preferably 12-40 carbon atoms, more preferably 14-32 carbon atoms.

In a more preferred embodiment of the invention, $Z^1$ is at each occurrence a direct bond and adjacent substituents $R^{II}$ do not combine to form an additional ring system.

In an even more preferred embodiment of the invention, the host is selected from the group consisting of the following structures:

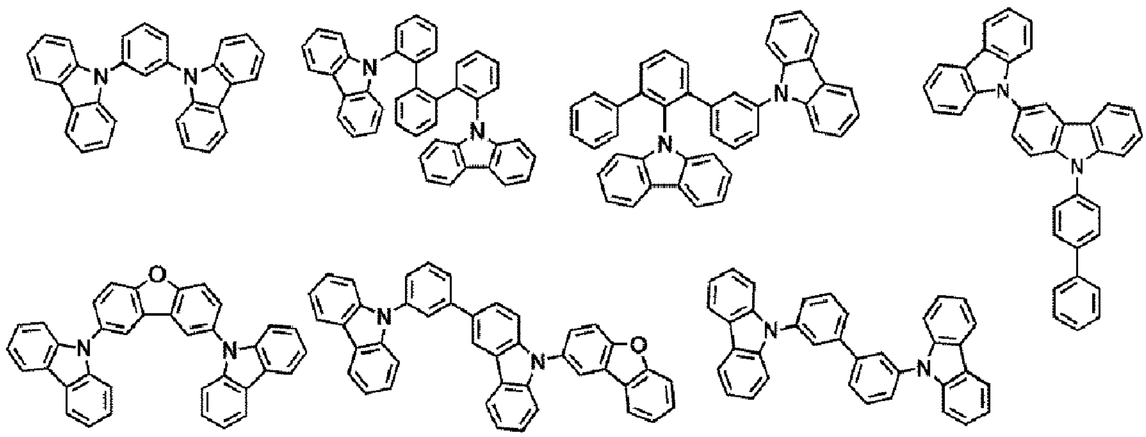

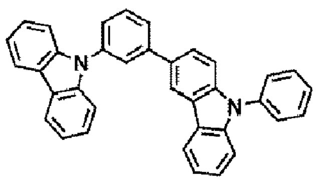

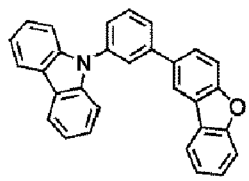

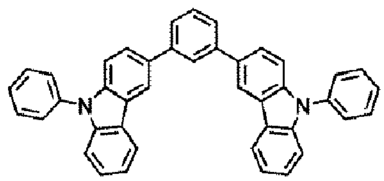

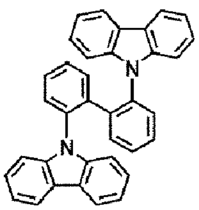
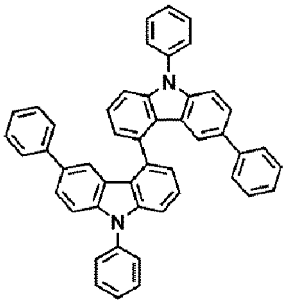
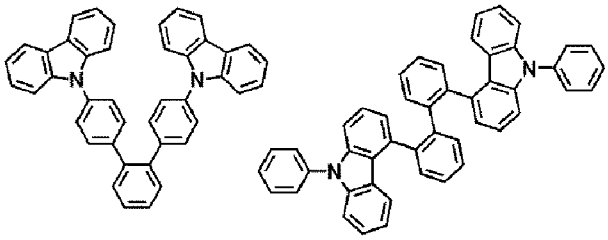

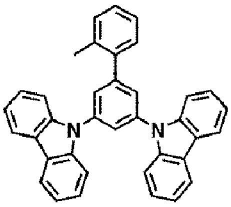
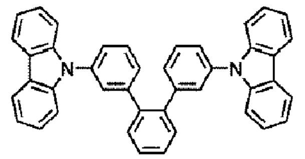
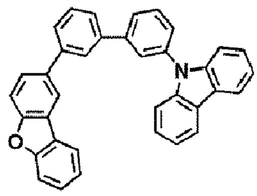
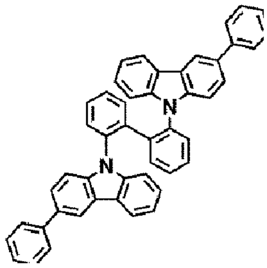

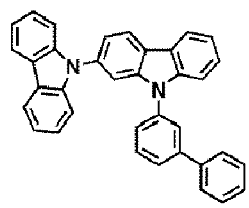
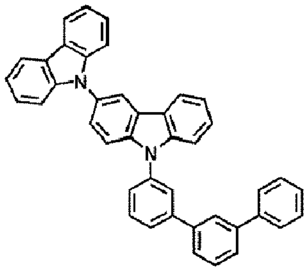
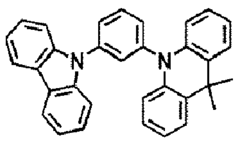
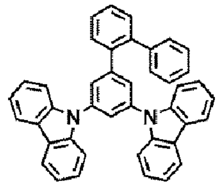

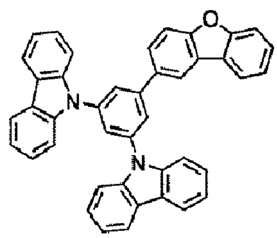
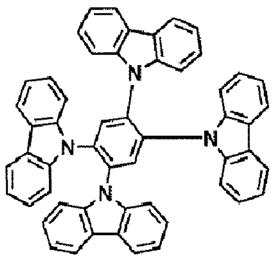
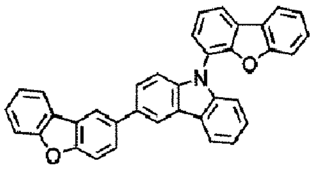
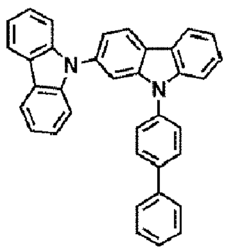

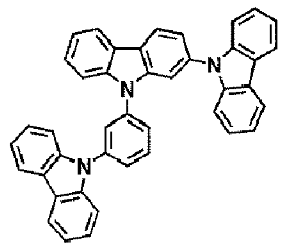
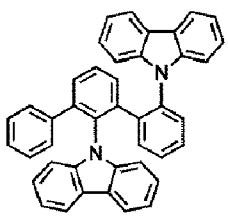
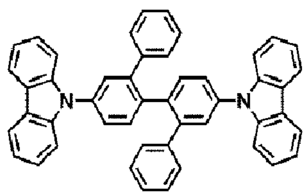
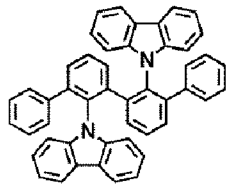

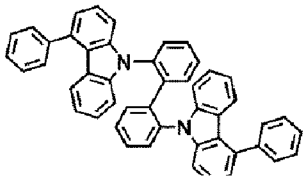
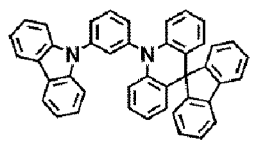
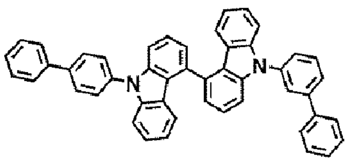

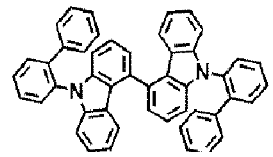

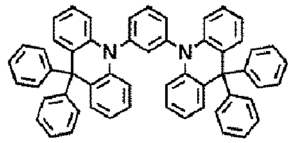

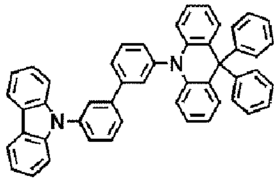

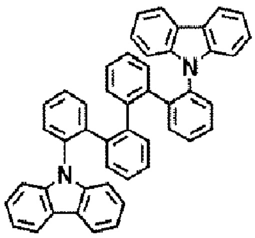

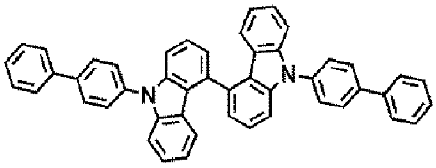

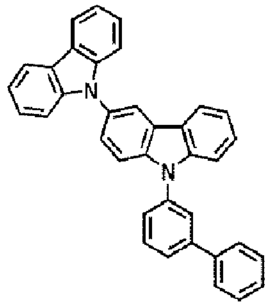

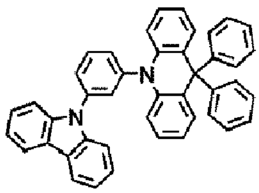

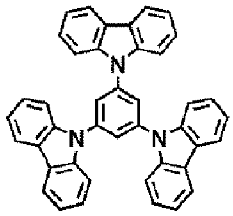

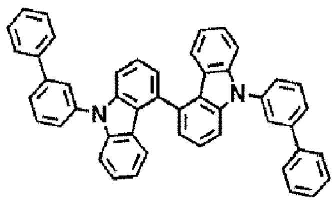

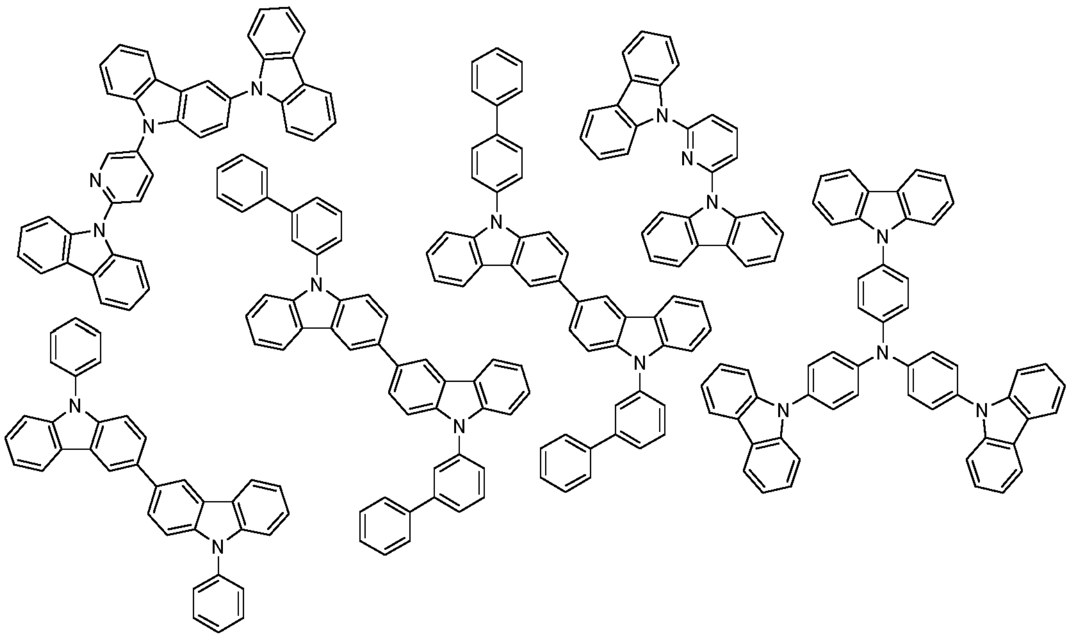

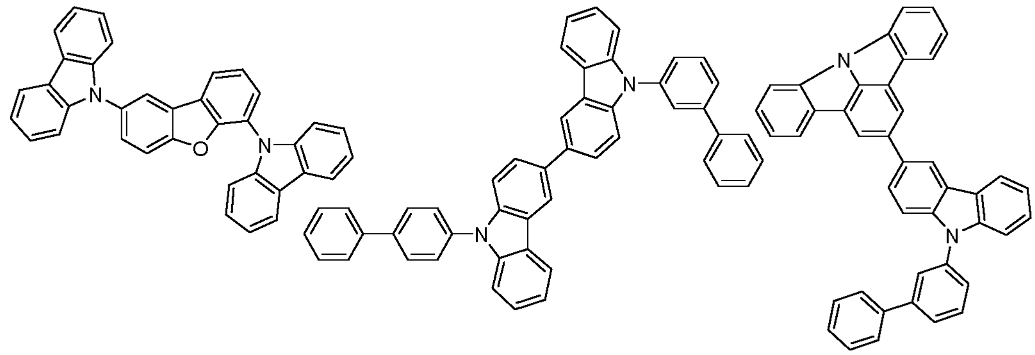

In a preferred embodiment of the invention the host compound comprises or consists of a structure according to any of the formulas $H^N$-I, $H^N$-II, and $H^N$-III:

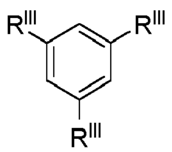

Formula $H^N$-I

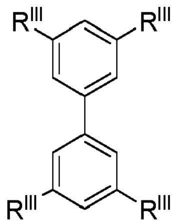

Formula $H^N$-II

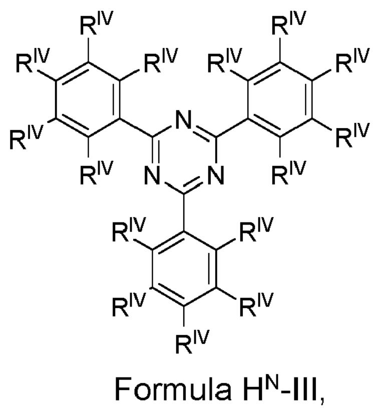

Formula $H^N$-III,

wherein $R^{III}$ and $R^{IV}$ are at each occurrence independently of each other selected from the group consisting of: hydrogen, deuterium, Me, $^i$Pr, $^t$Bu, CN, $CF_3$,

Ph, which is optionally substituted with one or more substituents independently of

each other selected from the group consisting of: Me, $^i$Pr, $^t$Bu, and Ph; and a structure represented by any of the formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV:

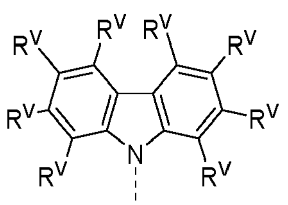

Formula $H^N$-IV

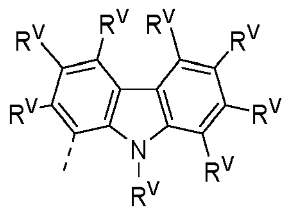

Formula $H^N$-V

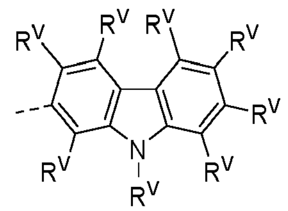

Formula $H^N$-VI

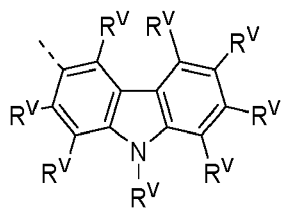

Formula $H^N$-VII

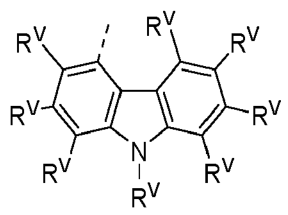

Formula $H^N$-VIII

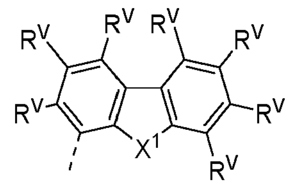

Formula $H^N$-IX

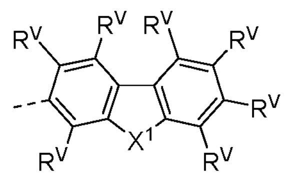

Formula $H^N$-X

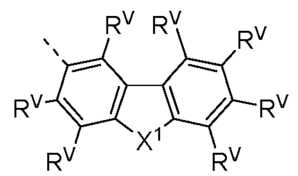

Formula $H^N$-XI

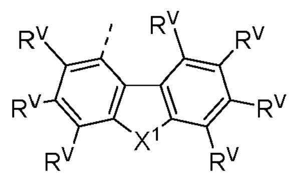

Formula $H^N$-XII

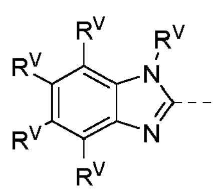

Formula $H^N$-XIII

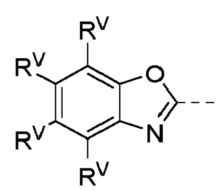

Formula $H^N$-XIV,

wherein

the dashed line indicates the binding site of a single bond connecting the structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV to a structure according to any of the formulas $H^N$-I, $H^N$-II, and $H^N$-III;

$X^1$ is oxygen (O), sulfur (S) or $C(R^V)_2$;

$R^V$ is at each occurrence independently of each other selected from the group consisting of: hydrogen, deuterium, Me, $^i$Pr, $^t$Bu, and

Ph, which is optionally substituted with one or more substituents independently of each other selected from the group consisting of: Me, $^i$Pr, $^t$Bu, and Ph;

wherein two or more adjacent substituents $R^V$ may optionally form a mono- or polycyclic, aliphatic or aromatic or heteroaromatic, carbo- or heterocyclic ring system so that the fused ring system consisting of a structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV as well as the additional rings optionally formed by adjacent substituents $R^V$ comprises in total 8-60 carbon atoms, preferably 12-40 carbon atoms, more preferably 14-32 carbon atoms; and

wherein in formulas $H^N$-I and $H^N$-II, at least one substituent $R^{III}$ is CN.

In an even more preferred embodiment of the host compound is selected from the group consisting of the following structures:

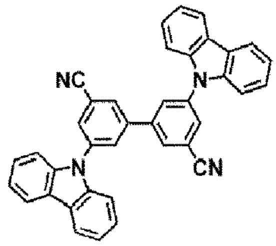

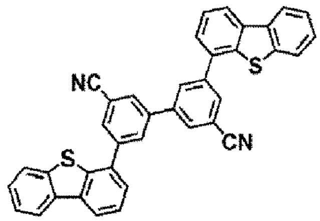

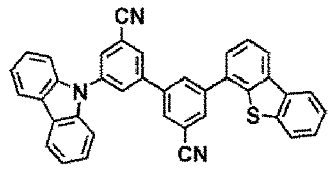

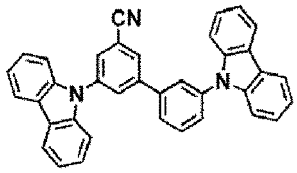

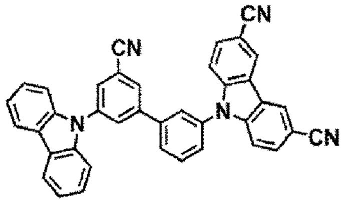

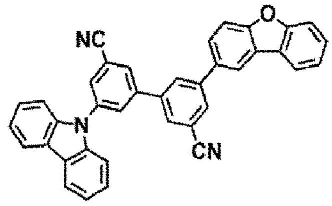

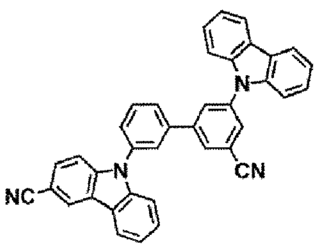

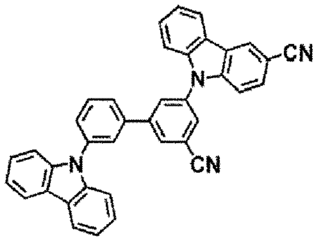

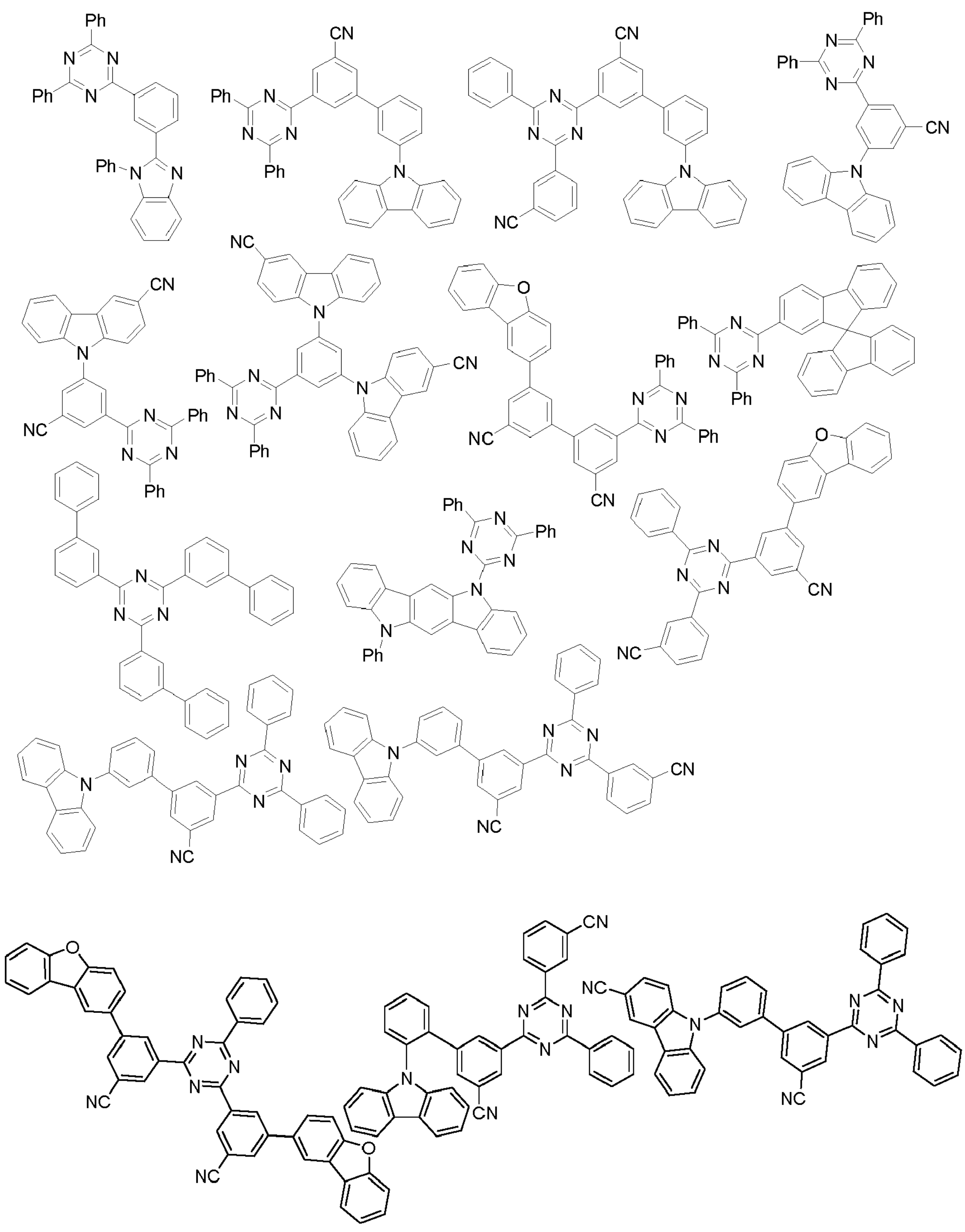

In one embodiment of the invention, the host compound doesn't contain any phosphine oxide groups and, in particular, the host compound is not bis[2-(diphenylphosphino)phenyl] ether oxide (DPEPO).

As used throughout the present application, the terms "aryl" and "aromatic" may be understood in the broadest sense as any mono-, bi- or polycyclic aromatic moieties. Accordingly, an aryl group contains 6 to 60 aromatic ring atoms, and a heteroaryl group contains 5 to 60 aromatic ring atoms, of which at least one is a heteroatom. Notwithstanding, throughout the application the number of aromatic ring atoms may be given as subscripted number in the definition of certain substituents. In particular, the heteroaromatic ring includes one to three heteroatoms. Again, the terms "heteroaryl" and "heteroaromatic" may be understood in the broadest sense as any mono-, bi- or polycyclic hetero-aromatic moieties that include at least one heteroatom. The heteroatoms may at each occurrence be the same or different and be individually selected from the group consisting of N, O and S. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring

atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term aryl group or heteroaryl group comprises groups which can be bound via any position of the aromatic or heteroaromatic group, derived from benzene, naphthaline, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine und benzothiadiazole or combinations of the abovementioned groups.

As used throughout the present application the term cyclic group may be understood in the broadest sense as any mono-, bi- or polycyclic moieties.

As used throughout the present application the term alkyl group may be understood in the broadest sense as any linear, branched, or cyclic alkyl substituent. In particular, the term alkyl comprises the substituents methyl (Me), ethyl (Et), n-propyl ($^n$Pr), i-propyl ($^i$Pr), cyclopropyl, n-butyl ($^n$Bu), i-butyl ($^i$Bu), s-butyl ($^S$Bu), t-butyl ($^t$Bu), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neohexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl und 1-(n-decyl)-cyclohex-1-yl.

As used throughout the present application the term alkenyl comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used throughout the present application the term alkynyl comprises linear, branched, and cyclic alkynyl substituents. The term alkynyl group exemplarily comprises ethynyl, propynyl, butynyl, pentynyl, hexynyl, heptynyl or octynyl.

As used throughout the present application the term alkoxy comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used throughout the present application the term thioalkoxy comprises linear, branched, and cyclic thioalkoxy substituents, in which the O of the exemplarily alkoxy groups is replaced by S.

As used throughout the present application, the terms "halogen" and "halo" may be understood in the broadest sense as being preferably fluorine, chlorine, bromine or iodine.

Whenever hydrogen is mentioned herein, it could also be replaced by deuterium at each occurrence.

It is understood that when a molecular fragment is described as being a substituent or otherwise attached to another moiety, its name may be written as if it were a fragment (e.g. naphtyl, dibenzofuryl) or as if it were the whole molecule (e.g. naphthalene, dibenzofuran). As used herein, these different ways of designating a substituent or attached fragment are considered to be equivalent.

In one embodiment of the invention, the organic molecules according to the invention represent thermally-activated delayed fluorescence (TADF) emitters, which exhibit a $\Delta E_{ST}$ value, which corresponds to the energy difference between the first excited singlet state (S1) and the first excited triplet state (T1), of less than 5000 $cm^{-1}$, preferably less than 3000 $cm^{-1}$, more preferably less than 1500 $cm^{-1}$, even more preferably less than 1000 $cm^{-1}$ or even less than 500 $cm^{-1}$.

Orbital and excited state energies can be determined either by means of experimental methods or by calculations employing quantum-chemical methods, in particular density functional theory calculations. The energy of the highest occupied molecular orbital $E^{HOMO}$ is determined by methods known to the person skilled in the art from cyclic voltammetry measurements with an accuracy of 0.1 eV. The energy of the lowest unoccupied molecular orbital $E^{LUMO}$ is determined as the onset of the absorption spectrum.

The onset of an absorption spectrum is determined by computing the intersection of the tangent to the absorption spectrum with the x-axis. The tangent to the absorption spectrum is set at the low-energy side of the absorption band and at the point at half maximum of the maximum intensity of the absorption spectrum.

The energy of the first excited triplet state T1 is determined from the onset of the emission spectrum at low temperature, typically at 77 K (for TADF materials $E^B$ a spin-coated film of 10% by weight of $E^B$ in PMMA is typically used; for small FWHM emitters $S^B$ a spin-coated film of 1-5%, preferably 2% by weight of $S^B$ in PMMA is typically used; for host materials $H^B$, a spin-coated neat film of the respective host material $H^B$ is typically used; for phosphorescence materials $P^B$ a spin-coated film of 10% by weight of $P^B$ in PMMA is typically used and the measurement is typically performed at room temperature (i.e. approximately 20 °C). As laid out for instance in EP2690681A1, it is acknowledged that for TADF materials $E^B$ with small $\Delta E_{ST}$ values, intersystem crossing and reverse intersystem crossing may both occur even at low temperatures. In consequence, the emission spectrum at 77K may include emission from both, the S1 and the T1 state. However, as also described in EP2690681A1, the contribution / value of the triplet energy is typically considered dominant. For host compounds, where the first excited singlet state and the lowest triplet state are energetically separated by > 0.4 eV, the phosphorescence is usually visible in a steady-state spectrum in 2-Me-THF. The triplet energy can thus be determined as the onset of the phosphorescence spectrum. For TADF emitter molecules, the energy of the first excited triplet state T1 is determined from the onset of the delayed emission spectrum at 77 K, if not otherwise stated measured in a film of) PMMA with 10% by weight of emitter. Both for host and emitter compounds, the energy of the first excited singlet state S1 is determined from the onset of the emission spectrum, if not otherwise stated measured in a film of PMMA with 10% by weight of host or emitter compound. The onset of an emission spectrum is determined by computing the intersection of the tangent to the emission spectrum with the x-axis. The tangent to the emission spectrum is set at the high-energy side of the emission band, i.e., where the emission band rises by going from higher energy values to lower energy values, and at the point at half maximum of the maximum intensity of the emission spectrum.

A further aspect of the invention relates to the use of an organic molecule according to the invention as a luminescent emitter in an optoelectronic device.

The optoelectronic device may be understood in the broadest sense as any device based on organic materials that is suitable for emitting light in the visible or nearest ultraviolet (UV) range, i.e., in the range of a wavelength of from 380 to 800 nm. More preferably, the optoelectronic device may be able to emit light in the visible range, i.e., of from 400 to 800 nm.

In the context of such use, the optoelectronic device is more particularly selected from the group consisting of:

- organic light-emitting diodes (OLEDs),
- light-emitting electrochemical cells,
- OLED sensors, especially in gas and vapour sensors not hermetically externally shielded,
- organic diodes,
- organic solar cells,
- organic transistors,
- organic field-effect transistors,
- organic lasers and
- down-conversion elements.

In a preferred embodiment in the context of such use, the optoelectronic device is a device selected from the group consisting of an organic light emitting diode (OLED), a light emitting electrochemical cell (LEC), and a light-emitting transistor.

*Optoelectronic devices*

In a further aspect, the invention relates to an optoelectronic device comprising an organic molecule or a composition as described herein, more particularly in the form of a device selected from the group consisting of organic light-emitting diode (OLED), light-emitting electrochemical cell, OLED sensor, more particularly gas and vapour sensors not hermetically externally shielded, organic diode, organic solar cell, organic transistor, organic field-effect transistor, organic laser, and down-conversion element.

In a preferred embodiment, the optoelectronic device is a device selected from the group consisting of an organic light emitting diode (OLED), a light emitting electrochemical cell (LEC), and a light-emitting transistor.

In one embodiment of the optoelectronic device of the invention, the organic molecule according to the invention is used as emission material in a light-emitting layer EML.

In one embodiment of the optoelectronic device of the invention, the light-emitting layer EML consists of the composition according to the invention described herein.

When the optoelectronic device is an OLED, it may, for example, exhibit the following layer structure:

1. substrate
2. anode layer A

3. hole injection layer, HIL
4. hole transport layer, HTL
5. electron blocking layer, EBL
6. emitting layer, EML
7. hole blocking layer, HBL
8. electron transport layer, ETL
9. electron injection layer, EIL
10. cathode layer,

wherein the OLED comprises each layer only optionally, different layers may be merged and the OLED may comprise more than one layer of each layer type defined above.

Furthermore, the optoelectronic device may optionally comprise one or more protective layers protecting the device from damaging exposure to harmful species in the environment including, exemplarily moisture, vapor and/or gases.

In one embodiment of the invention, the optoelectronic device is an OLED, which exhibits the following inverted layer structure:

1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A

wherein the OLED with an inverted layer structure comprises each layer only optionally, different layers may be merged and the OLED may comprise more than one layer of each layer types defined above.

In one embodiment of the invention, the optoelectronic device is an OLED, which may exhibit stacked architecture. In this architecture, contrary to the typical arrangement, where the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may optionally comprise a charge generation layer (CGL), which is typically located between two OLED subunits and typically consists of a n-doped and p-doped layer with the n-doped layer of one CGL being typically located closer to the anode layer.

In one embodiment of the invention, the optoelectronic device is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the anode layer A comprises a large content or even consists of transparent conductive oxides (TCOs). Such anode layer A may exemplarily comprise indium tin oxide, aluminum zinc oxide, fluorine doped tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene.

Preferably, the anode layer A (essentially) consists of indium tin oxide (ITO). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture

of PEDOT and PSS. The hole injection layer (HIL) may also prevent the diffusion of metals from the anode layer A into the hole transport layer (HTL). The HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL) typically a hole transport layer (HTL) is located. Herein, any hole transport compound may be used. Exemplarily, electron-rich heteroaromatic compounds such as triarylamines and/or carbazoles may be used as hole transport compound. The HTL may decrease the energy barrier between the anode layer A and the light-emitting layer EML. The hole transport layer (HTL) may also be an electron blocking layer (EBL). Preferably, hole transport compounds bear comparably high energy levels of their triplet states T1. Exemplarily the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA(4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may exemplarily be used as inorganic dopant. Tetrafluorotetracyanoquinodimethane (F4-TCNQ), copper-pentafluorobenzoate (Cu(I)pFBz) or transition metal complexes may exemplarily be used as organic dopant.

The EBL may, for example, comprise mCP (1,3-bis(carbazol-9-yl)benzene), TCTA, 2-TNATA, mCBP (3,3-di(9H-carbazol-9-yl)biphenyl), SiMCP (3,5-Di(9H-carbazol-9-yl)phenyl]triphenylsilane), DPEPO, tris-Pcz, CzSi (9-(4-tert-Butylphenyl)-3,6-bis(triphenylsilyl)-9H-carbazole), and/or DCB (N,N'-dicarbazolyl-1,4-dimethylbenzene).

Adjacent to the hole transport layer (HTL), the light-emitting layer EML is typically located. The light-emitting layer EML comprises at least one light emitting molecule. Particular, the EML comprises at least one light emitting molecule according to the invention. In one embodiment, the light-emitting layer comprises only the organic molecules according to the invention. Typically, the EML additionally comprises one or more host material. Exemplarily, the host material is selected from CBP (4,4'-Bis-(N-carbazolyl)-biphenyl), mCP, mCBP Sif87 (dibenzo[b,d]thiophen-2-yltriphenylsilane), CzSi, SimCP ([3,5-Di(9H-carbazol-9-yl)phenyl]triphenylsilane), Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). The host material typically should be selected to exhibit first triplet (T1) and first singlet (S1) energy levels, which are energetically higher than the first triplet (T1) and first singlet (S1) energy levels of the organic molecule.

In one embodiment of the invention, the EML comprises a so-called mixed-host system with at least one hole-dominant host and one electron-dominant host. In a particular embodiment, the EML comprises exactly one light emitting molecule species according to the invention and a mixed-host system comprising T2T as electron-dominant host and a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as hole-dominant host. In a further embodiment the EML comprises 50-80 % by weight, preferably 60-75 % by weight of a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole; 10-45 % by weight, preferably 15-30 % by weight of T2T and 5-40 % by weight, preferably 10-30 % by weight of light emitting molecule according to the invention.

Adjacent to the light-emitting layer EML an electron transport layer (ETL) may be located. Herein, any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. An electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL may be doped with materials such as Liq. The electron transport layer (ETL) may also block holes or a holeblocking layer (HBL) is introduced.

The HBL may, for example, comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

A cathode layer C may be located adjacent to the electron transport layer (ETL). For example, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) nontransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride, silver, Liq (8-hydroxyquinolinolatolithium), $Li_2O$, $BaF_2$, MgO and/or NaF.

Optionally, also the electron transport layer (ETL) and/or a hole blocking layer (HBL) may comprise one or more host compounds.

In order to modify the emission spectrum and/or the absorption spectrum of the light-emitting layer EML further, the light-emitting layer EML may further comprise one or more further emitter molecule F. Such an emitter molecule F may be any emitter molecule known in the art. Preferably such an emitter molecule F is a molecule with a structure differing from the structure of the molecules according to the invention.

The emitter molecule F may optionally be a TADF emitter. Alternatively, the emitter molecule F may optionally be a fluorescent and/or phosphorescent emitter molecule which is able to shift the emission spectrum and/or the absorption spectrum of the light-emitting layer EML. Exemplarily, the triplet and/or singlet excitons may be transferred from the emitter molecule according to the invention to the emitter molecule F before relaxing to the ground state S0 by emitting light typically redshifted in comparison to the light emitted by emitter molecule E. Optionally, the emitter molecule F may also provoke two-photon effects (i.e., the absorption of two photons of half the energy of the absorption maximum).

Optionally, an optoelectronic device (e.g., an OLED) may exemplarily be an essentially white optoelectronic device. Exemplarily such white optoelectronic device may comprise at least one (deep) blue emitter molecule and one or more emitter molecules emitting green and/or red light. Then, there may also optionally be energy transmittance between two or more molecules as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter molecules, such colors refer to the emission maximum. Therefore, exemplarily, a deep blue emitter has an emission maximum in the range of from >420 to 480 nm, a sky-blue emitter has an emission maximum in the range of from >480 to 500 nm, a green emitter has an emission maximum in a range of from >500 to 560 nm, a red emitter has an emission maximum in a range of from >620 to 800 nm.

A further embodiment of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as described throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further embodiment of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even more preferably between 0.03 and 0.15 or even between 0.04 and 0.10.

A further embodiment of the present invention relates to an OLED, which emits light with CIEx and CIEy color coordinates close to the CIEx (= 0.170) and CIEy (= 0.797) color coordinates of the primary color green (CIEx = 0.170 and CIEy = 0.797) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further aspect of the present invention relates to an OLED, whose emission exhibits a CIEx color coordinate of between 0.06 and 0.34, preferably between 0.07 and 0.29, more preferably between 0.09 and 0.24 or even more preferably between 0.12 and 0.22 or even between 0.14 and 0.19 and/ or a CIEy color coordinate of between 0.75 and 1.20, preferably between 0.76 and 1.05, more preferably between 0.77 and 0.95 or even more preferably between 0.78 and 0.90 or even between 0.79 and 0.85.

A further embodiment of the present invention relates to an OLED, which emits light with CIEx and CIEy color coordinates close to the CIEx (= 0.708) and CIEy (= 0.292) color coordinates of the primary color red (CIEx = 0.708 and CIEy = 0.292) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further aspect of the present invention relates to an OLED, whose emission exhibits a CIEx color coordinate of between 0.60 and 0.88, preferably between 0.61 and 0.83, more preferably between 0.63 and 0.78 or even more preferably between 0.66 and 0.76 or even between 0.68 and 0.73 and/ or a CIEy color coordinate of between 0.25 and 0.70, preferably between 0.26 and 0.55, more preferably between 0.27 and 0.45 or even more preferably between 0.28 and 0.40 or even between 0.29 and 0.35.

Accordingly, a further aspect of the present invention relates to an OLED, which exhibits an external quantum efficiency at 1000 cd/m$^2$ of more than 8%, more preferably of more than 10%, more preferably of more than 13%, even more preferably of more than 15% or even more than 20% and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/m$^2$ of more than 100 h, preferably more than 200 h, more preferably more than 400 h, even more preferably more than 750 h or even more than 1000 h.

The optoelectronic device, in particular the OLED according to the present invention can be produced by any means of vapor deposition and/ or liquid processing. Accordingly, at least one layer is

- prepared by means of a sublimation process,
- prepared by means of an organic vapor phase deposition process,
- prepared by means of a carrier gas sublimation process,
- solution processed or printed.

The methods used to produce the optoelectronic device, in particular the OLED according to the present invention are known in the art. The different layers are individually and successively deposited on a suitable substrate by means of subsequent deposition processes. The individual layers may be deposited using the same or differing deposition methods.

Vapor deposition processes exemplarily comprise premix evaporation, thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process exemplarily comprise spin coating, dip coating and jet printing. Liquid processing may optionally be carried out in an inert atmosphere (e.g., in a nitrogen atmosphere) and the solvent may optionally be completely or partially removed by means known in the state of the art.

## Examples

*Cyclic voltammetry*

Cyclic voltammograms of solutions having concentration of 10-3 mol/l of the organic molecules in dichloromethane or a suitable solvent and a suitable supporting electrolyte (e.g. 0.1 mol/l of tetrabutylammonium hexafluorophosphate) are measured. The measurements are conducted at room temperature and under nitrogen atmosphere with a three-electrode assembly (Working and counter electrodes: Pt wire, reference electrode: Pt wire) and calibrated using $FeCp_2/FeCp_2^+$ as internal standard. HOMO data was corrected using ferrocene as internal standard against SCE.

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration were used. The Turbomole program package was used for all calculations.

*Photophysical measurements*

Sample pretreatment: Spin-coating
Apparatus: Spin150, SPS euro.
The sample concentration is 10 mg/ml, dissolved in a suitable solvent.
Program: 1) 3 s at 400 U/min; 20 s at 1000 U/min at 1000 Upm/s. 3) 10 s at 4000 U/min at 1000 Upm/s. After coating, the films are tried at 70 °C for 1 min. Photoluminescence spectroscopy and TCSPC *(Time-correlated single-photon counting)*
Steady-state emission spectroscopy is recorded using a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.

Excited state lifetimes are determined employing the same system using the TCSPC method with FM-2013 equipment and a Horiba Yvon TCSPC hub.

Excitation sources:

NanoLED 370 (wavelength: 371 nm, puls duration: 1,1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) was done using the software suite DataStation and DAS6 analysis software. The fit is specified using the chi-squared-test.

*Photoluminescence quantum yield measurements*

For photoluminescence quantum yield (PLQY) measurements an *Absolute PL Quantum Yield Measurement C9920-03G* system *(Hamamatsu Photonics)* is used. Quantum yields and CIE coordinates were determined using the software U6039-05 version 3.6.0.

Emission maxima are given in nm, quantum yields $\Phi$ in % and CIE coordinates as x,y values.

PLQY was determined using the following protocol:

1) Quality assurance: Anthracene in ethanol (known concentration) is used as reference
2) Excitation wavelength: the absorption maximum of the organic molecule is determined and the molecule is excited using this wavelength
3) Measurement

Quantum yields are measured for sample of solutions or films under nitrogen atmosphere. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. is the intensity.

*Production and characterization of organic electroluminescence devices*

Via vacuum-deposition methods OLED devices comprising organic molecules according to the invention can be produced. If a layer contains more than one compound, the weight-percentage of one or more compounds is given in %. The total weight-percentage values amount to 100 %, thus if a value is not given, the fraction of this compound equals to the difference between the given values and 100%.

The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT97 to the time point, at which the measured luminance decreased to 97 % of the initial luminance etc.

Accelerated lifetime measurements are performed (e.g. applying increased current densities). Exemplarily LT80 values at 500 cd/m$^2$ are determined using the following equation:

$$\mathrm{LT80}\left(500\frac{cd^2}{m^2}\right) = \mathrm{LT80}(L_0)\left(\frac{L_0}{500\frac{cd^2}{m^2}}\right)^{1.6}$$

wherein $L_0$ denotes the initial luminance at the applied current density.

The values correspond to the average of several pixels (typically two to eight), the standard deviation between these pixels is given. Figures show the data series for one OLED pixel.

**HPLC-MS**

HPLC-MS analysis is performed on an HPLC by Agilent (1260 series) with MS-detector (Thermo LTQ XL).

For example, a typical HPLC method is as follows: a reverse phase column 3.0 mm x 100 mm, particle size 2.7 µm from Agilent *(Poroshell 120EC-C18, 3.0 x 100 mm, 2.7 µm HPLC column)* is used in the HPLC. The HPLC-MS measurements are performed at room temperature (rt) following gradients

| Flow rate [ml/min] | Time [min] | A[%] | B[%] | C[%] |
|---|---|---|---|---|
| 1.5 | 30 | 40 | 40 | 30 |
| 1.5 | 45 | 10 | 10 | 80 |
| 1.5 | 50 | 40 | 10 | 80 |
| 1.5 | 51 | 30 | 40 | 30 |
| 1.5 | 55 | 30 | 10 | 30 |

using the following solvent mixtures containing 0.1% formic acid:

| | | |
|---|---|---|
| Solvent A: | H2O (10%) | MeCN (90%) |
| Solvent B: | H2O (90%) | MeCN (10%) |
| Solvent C: | THF (50%) | MeCN (50%) |

An injection volume of 2 µL from a solution with a concentration of 0.5 mg/mL of the analyte is taken for the measurements.

Ionization of the probe is performed using an atmospheric pressure chemical ionization (APCI) source either in positive (APCI +) or negative (APCI -) ionization mode or an atmospheric pressure photoionization (APPI) source.

## Examples

Table 1 shows evaporation temperatures (Tevap) for exemplary first and second compounds disclosed herein at a deposition rate of 0.8 Å/s at a pressure of <$10^{-6}$ torr. The evaporation temperatures are obtained by adjusting the temperature until the desired deposition rate of 0.8 Å/s at pressure of <$10^{-6}$ torr was reached. The temperature which is necessary to obtain the evaporation rate of 0.8 Å/s at a pressure of <$10^{-6}$ torr are the given evaporation temperatures in table 1. The evaporation temperatures are used for determination of the first compound and the second compound.

Exemplary first compounds and second compounds according to the present invention are presented below:

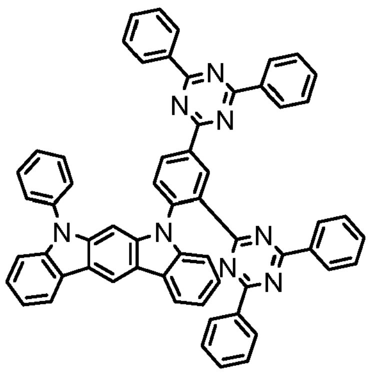

T1

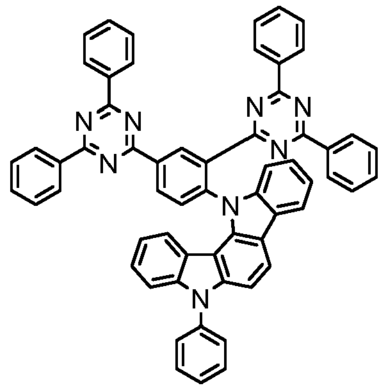

T2

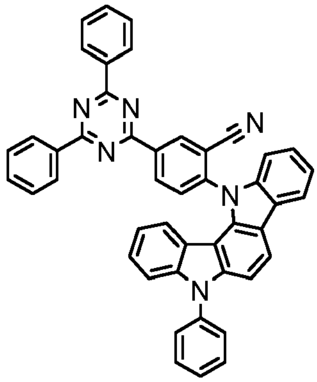

T3

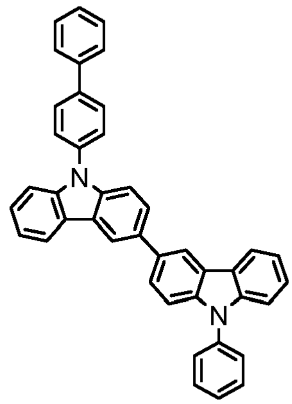

H1

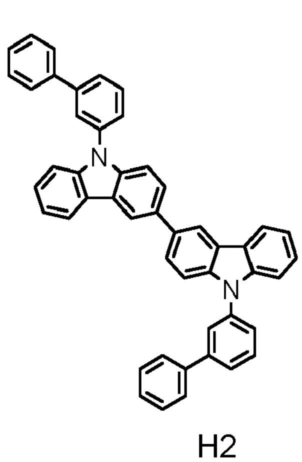

H2

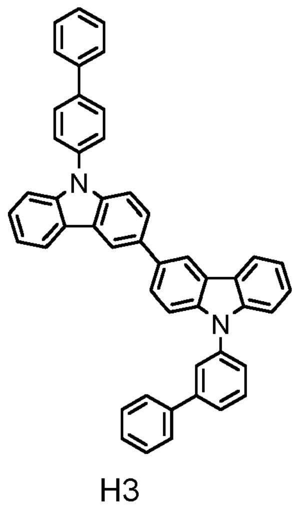

H3

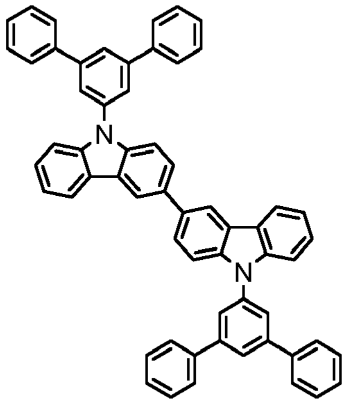

H4

Table 1

| Compound | Tevap (°C) at deposition rate of 0.8 Å/s at <10$^{-6}$ torr |
|---|---|
| T1 | 319 |
| T2 | 295 |
| T3 | 271 |
| H1 | 269 |
| H2 | 280 |
| H3 | 285 |
| H4 | 332 |

Based on the data shown in table 1 a pair of one host (H) compound and one TADF compound (T) are exemplary used for fabricating two devices, where the first device D1 was produced with the method described in the present invention, wherein the first compound is represented by host compound H3 and the second compound is represented by TADF compound T2 and wherein compound H3 and compound T2 are mixed together and evaporated together out of one container in the thermal evaporation device. The difference between the evaporation temperature of host compound H3 and TADF compound T2 is 10 °C and is in the preferred range of +/-10 °C. The composition consisting of the mixture of first compound H3 and the second compound T2 is obtained by mixing both compounds together and homogenizing the mixture by heating the mixture above the melting point. The homogenized mixture of compound H3 and compound T2 was cooled to room temperature and was used as such in one container of the thermal evaporation device. For comparison the comparative example C1 was prepared by the conventional co-evaporation process, where host compound H3 and TADF compound T2 were evaporated out of separate containers. The composition of the light-emitting layer of device example D1 and comparative device example C1 are obtained by using the previously described standard HPLC measurement. The values are stated in Table 2.

Further compound used in the device examples are listed below:

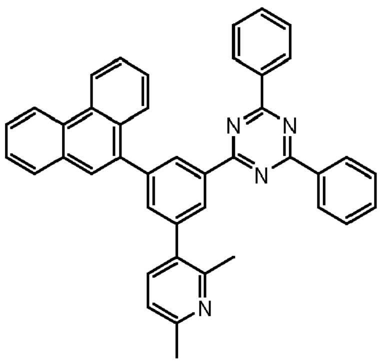

ETL1

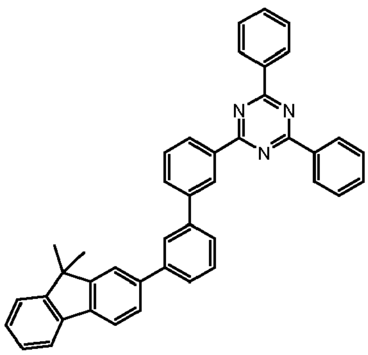

HBL1

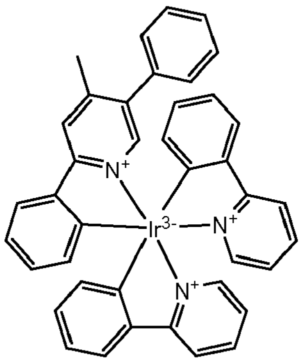

P1

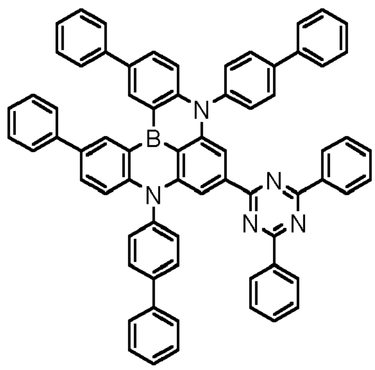

DABNA1

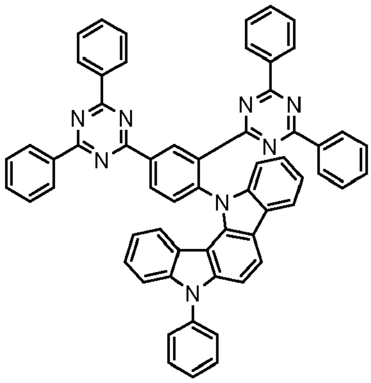

TADF1

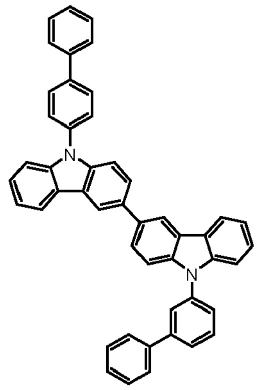

HOST1

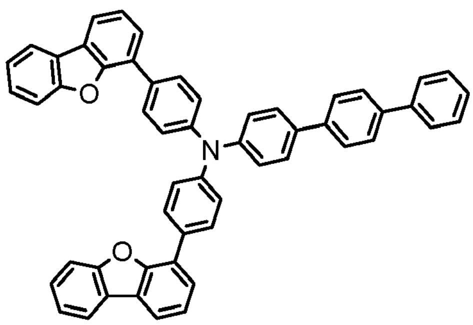

HTL1

Table 2

| Layer | Thickness | D1 | C1 |
|---|---|---|---|
| 9 | 100 nm | Al | Al |
| 8 | 2 nm | Liq | Liq |
| 7 | 46 nm | ETL1 (50%) Liq (50%) | ETL1 (50%) Liq (50%) |
| 6 | 5 nm | HBL1 | HBL1 |
| 5 | 40 nm | P1 (3%)<br>DABNA1 (0.7%)<br>TADF1 (15.5%)<br>HOST1 (80.8%) | P1 (3%)<br>DABNA1 (0.7%)<br>TADF1(15%)<br>HOST1 (81.3%) |

(continued)

| Layer | Thickness | D1 | C1 |
|---|---|---|---|
| 4 | 10 nm | HTL1 | HTL1 |
| 3 | 51 nm | NPB | NPB |
| 2 | 9 nm | NPB:NDP-9 | NPB:NDP-9 |
| 1 | 50 nm | ITO | ITO |
| substrate | | glass | glass |

Device **D1** yielded an external quantum efficiency (EQE) at 1000 cd/$m^2$ of 28.1%. The LT97 value at 1200 cd/$m^2$ was determined to be 6306 h from accelerated lifetime measurements. The emission maximum is at 532 nm with a FWHM of 42 nm at 10 mA/$cm^2$. The corresponding CIEy value is 0.64.

Comparative device **C1** yielded an external quantum efficiency (EQE) at 1000 cd/$m^2$ of 26.3%. The LT97 value at 1200 cd/$m^2$ was determined to be 3016 h from accelerated lifetime measurements. The emission maximum is at 532 nm with a FWHM of 42 nm at 10 mA/$cm^2$. The corresponding CIEy value is 0.64.

## Claims

**1.** A light-emitting layer for use in an organic electroluminescent device, wherein the light-emitting layer is obtained from evaporation of a composition comprising a mixture of a first compound and a second compound, which are provided in one container; wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure between $1x10^{-6}$ Torr to $1x10^{-8}$ Torr; wherein the temperature difference T1-T2 is in a range between -40 °C to 40 °C, preferably between - 20 °C and 20 °C, more preferably between -10 °C and 10 °C; wherein the first and second compound is each selected from a host material and a thermally activated delayed fluorescence (TADF) emitter, wherein at least one of the first compound and the second compound is a TADF emitter.

**2.** The light-emitting layer of claim 1, wherein one or more further compounds of the light-emitting layer are co-evaporated out of one or more further containers.

**3.** The organic electroluminescent device according to claim 1 or 2, wherein the emission layer comprises at least:

(i) the composition comprising a mixture of a first compound and a second compound; and
(ii) one further host or emitter compound.

**4.** The organic electroluminescent device according to any of claim 1 to 3, wherein the emission layer comprises at least one small full width at half maximum (FWHM) emitter.

**5.** The organic electroluminescent device according to any of claim 1 to 4, wherein the emission layer comprises at least:

(i) the first compound;
(ii) the second compound;
(iii) one small FWHM emitter and
(iv) a phosphorescent emitter.

**6.** A composition according to any of claims 1 to 5, wherein the TADF emitter is **characterized in that**:

(i) it exhibit a ΔEST value, which corresponds to the energy difference between the lowermost excited singlet state energy E(S1E) and the lowermost excited triplet state energy E(T1E), of less than 0.4 eV; and
(ii) it displays a photoluminescence quantum yield (PLQY) of more than 30%.

**7.** A composition according to any of claim 1 to 6, wherein the TADF compound is represented by Formula T-I,

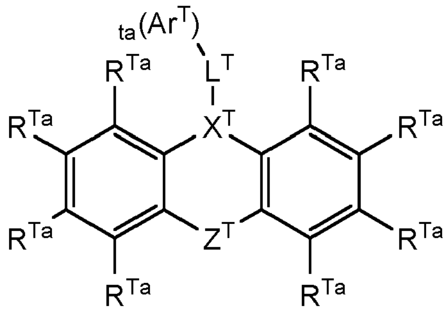

Formula T-I

wherein in Formula T-I

$X^T$ is selected from the group consisting of N and $CR^{Ta}$;
$Z^T$ is at each occurrence independently from another selected from the group consisting of: a direct bond, $CR^{Tb}R^{Tc}$, $C=CR^{Tb}R^{Tc}$, C=O, $C=NR^{Tb}$, $NR^{Tb}$, O, $SiR^{Tb}R^{Tc}$, S, S(O), and $S(O)_2$;
$L^T$ is selected from the group consisting of substituted or unsubstituted $C_6$-$C_{60}$-arylene and substituted or unsubstituted $C_3$-$C_{57}$-heteroarylene;
$Ar^T$ is selected from the group consisting of substituted or unsubstituted $C_6$-$C_{60}$-aryl and substituted or unsubstituted $C_3$-$C_{57}$-heteroaryl;
ta is an integer selected from 1 and 2;
$R^{Ta}$, $R^{Tb}$, $R^{Tc}$ are at each occurrence independently from another selected from the group consisting of: hydrogen, deuterium, $N(R^{T5})_2$, O $R^{T5}$, $Si(R^{T5})_3$, $B(OR^{T5})_2$, $OSO_2R^{T5}$, $CF_3$, CN, F, Br, I,
$C_1$-$C_{40}$-alkyl,
which is optionally substituted with one or more substituents $R^{T5}$ and wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-alkoxy,
which is optionally substituted with one or more substituents $R^{T5}$ and wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-thioalkoxy,
which is optionally substituted with one or more substituents $R^{F5}$ and wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkenyl,
which is optionally substituted with one or more substituents $R^{F5}$ and wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkynyl,
which is optionally substituted with one or more substituents $R^{F5}$ and wherein one or more non-adjacent $CH_2$-groups are optionally substituted by $R^{T5}C=CR^{T5}$, C=C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_6$-$C_{60}$-aryl,
which is optionally substituted with one or more substituents $R^{T5}$; $C_3$-$C_{57}$-heteroaryl,
which is optionally substituted with one or more substituents $R^{T5}$;
$R^{T5}$ is at each occurrence independently from another selected from the group consisting of hydrogen, deuterium, $CF_3$, CN, F, Br, I,
$C_1$-$C_{40}$-alkyl,
$C_1$-$C_{40}$-alkoxy,
$C_1$-$C_{40}$-thioalkoxy,
$C_2$-$C_{40}$-alkenyl,
$C_2$-$C_{40}$-alkynyl,
$C_6$-$C_{60}$-aryl,
$C_3$-$C_{57}$-heteroaryl;

**8.** The composition according to any of claim 1 to 7 wherein the host compound comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^P$-X:

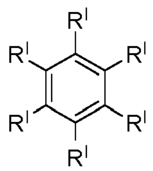

Formula $H^P$-I

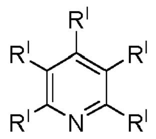

Formula $H^P$-II

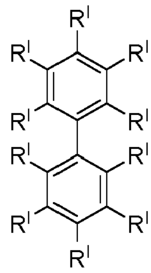

Formula $H^P$-III

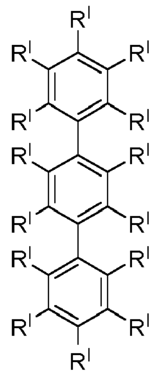

Formula $H^P$-IV

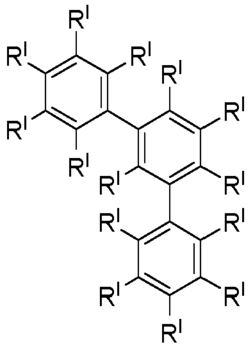

Formula $H^P$-V

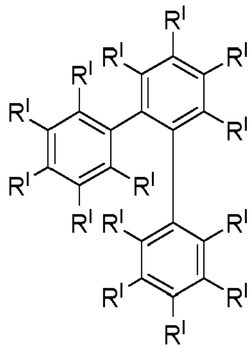

Formula $H^P$-VI

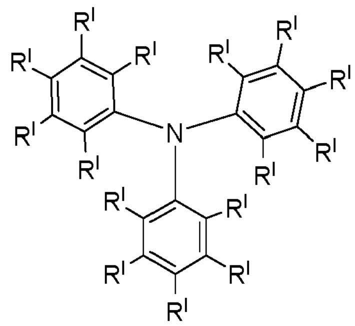

Formula $H^P$-VII

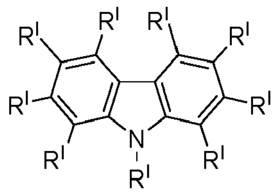

Formula $H^P$-VIII

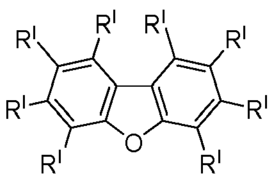

Formula $H^P$-IX

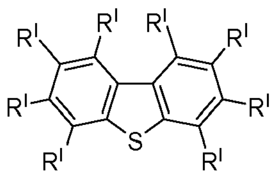

Formula $H^P$-X

and

- one or more second chemical moieties, each comprising or consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

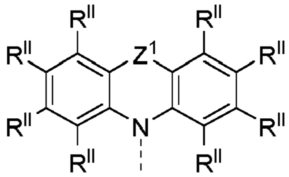

Formula $H^P$-XI

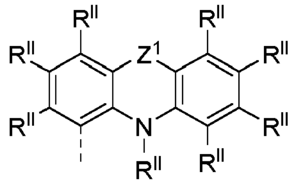

Formula $H^P$-XII

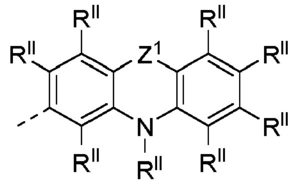

Formula $H^P$-XIII

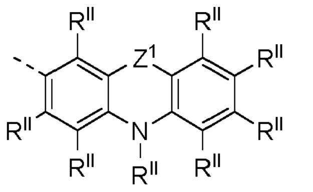

Formula $H^P$-XIV

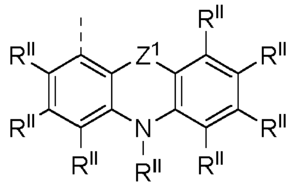

Formula $H^P$-XV

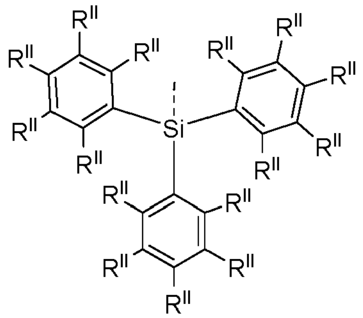

Formula $H^P$-XVI

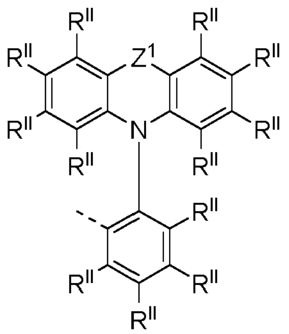

Formula $H^P$-XVII

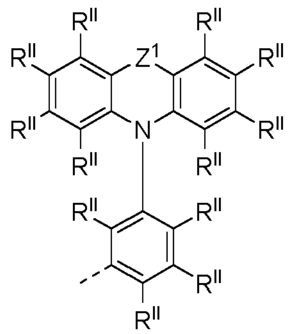

Formula $H^P$-XVIII

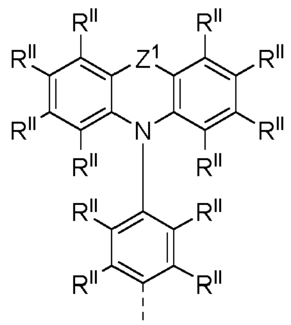

Formula $H^P$-XIX,

wherein each of the one or more second chemical moieties which is present in the host, in particular a p-host material $H^P$, is linked to the first chemical moiety via a single bond which is represented in the formulas above by a dashed line;

wherein

$Z^1$ is at each occurrence independently of each other selected from the group consisting of a direct bond, $C(R^{II})_2$, $C=C(R^{II})_2$, C=O, $C=NR^{II}$, $NR^{II}$, O, $Si(R^{II})_2$, S, S(O) and $S(O)_2$;

$R^I$ is at each occurrence independently of each other a binding site of a single bond linking the first chemical moiety to a second chemical moiety or is selected from the group consisting of hydrogen, deuterium, Me, $^i$Pr, and $^t$Bu, and

Ph, which is optionally substituted with one or more substituents independently of each other selected from the group consisting of: Me, $^i$Pr, $^t$Bu, and Ph;

wherein at least one $R^I$ is a binding site of a single bond linking the first chemical moiety to a second chemical moiety;

$R^{II}$ is at each occurrence independently of each other selected from the group consisting of: hydrogen, deuterium, Me, $^i$Pr, $^t$Bu, and

Ph, which is optionally substituted with one or more substituents independently of each other selected from the group consisting of: Me, $^i$Pr, $^t$Bu, and Ph;

wherein two or more adjacent substituents $R^{II}$ may optionally form a mono- or polycyclic, aliphatic or aromatic or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents $R^{II}$ comprises in total 8-60 carbon atoms preferably 12-40 carbon atoms, more preferably 14-32 carbon atoms.

**9.** A method for generating a light-emitting layer, comprising the steps:

(i) mixing a first compound and a second compound together to form a homogeneous mixture, wherein the first compound has a different chemical structure than the second compound; wherein the first compound has an evaporation temperature T1 between 150 to 400 °C and the second compound has an evaporation temperature

T2 between 150 and 400 °C; wherein the evaporation temperature is measured in the vacuum deposition chamber at a deposition rate of 0.08 nm/sec (0.8 Å/sec) at a constant pressure $1x10^{-6}$ Torr to $1x10^{-8}$ Torr; wherein the temperature difference T1-T2 is in a range between -40 °C to 40 °C, preferably between -20 °C and 20 °C, more preferably between -10 °C and 10 °C; wherein the first and second compound each is selected from a host material and a TADF emitter, wherein at least one of the first compound and the second compound is a TADF emitter; and

(ii) evaporating the homogeneous mixture of the first compound and the second compound together out of one container, wherein further compounds can optionally be co-evaporated out of one or more further containers.

**10.** The method according to claim 9, wherein the organic electroluminescent device comprises a light emitting layer comprising at least:

(i) the first compound;
(ii) the second compound;
(iii) one small FWHM emitter and
(iv) a phosphorescent emitter.

**11.** The method according to claim 9 or 10 comprising the steps

(i) Providing a composition according to any of claims 1 to 8;
(ii) Optionally homogenizing of the composition by

a. grinding, and/or
b. liquefying the composition by heating above the melting temperature of the first compound and the second compound depending on which compound has the higher melting point and subsequent cooling, and/or
c. dissolving the composition in a solvent or a mixture of solvents and subsequent removal of the solvent;

(iii) Evaporation of the composition; and
(iv) Optional co-evaporation of additional compounds.

**Amended claims in accordance with Rule 137(2) EPC.**

**1.** A light-emitting layer for use in an organic electroluminescent device, wherein the light-emitting layer is obtained from evaporation of a composition comprising a mixture of a first compound and a second compound, which are provided in one container; wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure between $1.33\times10^{-4}$ Pa ($1\times10^{-6}$ Torr) to $1.33\times10^{-6}$ Pa ($1\times10^{-8}$ Torr); wherein the temperature difference T1-T2 is in a range between -40 °C to 40 °C, preferably between -20 °C and 20 °C, more preferably between -10 °C and 10 °C; wherein the first and second compound is each selected from a host material and a thermally activated delayed fluorescence (TADF) emitter, wherein at least one of the first compound and the second compound is a TADF emitter.

**2.** The light-emitting layer of claim 1, wherein one or more further compounds of the light-emitting layer are co-evaporated out of one or more further containers.

**3.** The light-emitting layer according to claim 1 or 2, wherein the emission layer comprises at least:

(i) the composition comprising a mixture of a first compound and a second compound; and
(ii) one further host or emitter compound.

**4.** The light-emitting layer according to any of claim 1 to 3, wherein the emission layer comprises at least one small full width at half maximum (FWHM) emitter.

**5.** The light-emitting layer according to any of claim 1 to 4, wherein the emission layer comprises at least:

(i) the first compound;

(ii) the second compound;
(iii) one small FWHM emitter and
(iv) a phosphorescent emitter.

**6.** A light-emitting layer according to any of claims 1 to 5, wherein the TADF emitter is **characterized in that**:

(i) it exhibit a ΔEST value, which corresponds to the energy difference between the lowermost excited singlet state energy E(S1E) and the lowermost excited triplet state energy E(T1E), of less than 0.4 eV; and
(ii) it displays an absolute photoluminescence quantum yield (PLQY) of more than 30%.

**7.** A light-emitting layer according to any of claim 1 to 6, wherein the TADF compound is represented by Formula T-I,

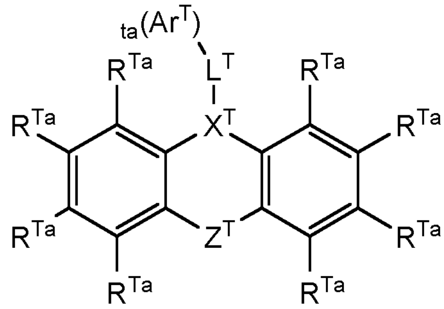

Formula T-I

wherein in Formula T-I

$X^T$ is selected from the group consisting of N and $CR^{Ta}$;
$Z^T$ is at each occurrence independently from another selected from the group consisting of: a direct bond, $CR^{Tb}R^{Tc}$, $C=CR^{Tb}R^{Tc}$, C=O, $C=NR^{Tb}$, $NR^{Tb}$, O, $SiR^{Tb}R^{Tc}$, S, S(O), and $S(O)_2$;
$L^T$ is selected from the group consisting of substituted or unsubstituted $C_6$-$C_{60}$-arylene and substituted or unsubstituted $C_3$-$C_{57}$-heteroarylene;
$Ar^T$ is selected from the group consisting of substituted or unsubstituted $C_6$-$C_{60}$-aryl and substituted or unsubstituted $C_3$-$C_{57}$-heteroaryl;
ta is an integer selected from 1 and 2;
$R^{Ta}$, $R^{Tb}$, $R^{Tc}$ are at each occurrence independently from another selected from the group consisting of: hydrogen, deuterium, $N(R^{T5})_2$, O $R^{T5}$, $Si(R^{T5})_3$, $B(OR^{T5})_2$, $OSO_2R^{T5}$, $CF_3$, CN, F, Br, I,
$C_1$-$C_{40}$-alkyl,
which is optionally substituted with one or more substituents $R^{T5}$ and wherein one or more non-adjacent $CH_2$-groups are optionally substituted by $R^{T5}C=CR^{T5}$, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-alkoxy,
which is optionally substituted with one or more substituents $R^{T5}$ and wherein one or more non-adjacent $CH_2$-groups are optionally substituted by $R^{T5}C=CR^{T5}$, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_1$-$C_{40}$-thioalkoxy,
which is optionally substituted with one or more substituents $R^{F5}$ and wherein one or more non-adjacent $CH_2$-groups are optionally substituted by $R^{T5}C=CR^{T5}$, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkenyl,
which is optionally substituted with one or more substituents $R^{F5}$ and wherein one or more non-adjacent $CH_2$-groups are optionally substituted by $R^{T5}C=CR^{T5}$, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;
$C_2$-$C_{40}$-alkynyl,
which is optionally substituted with one or more substituents $R^{F5}$ and wherein one or more non-adjacent $CH_2$-groups are optionally substituted by $R^{T5}C=CR^{T5}$, C≡C, $Si(R^{T5})_2$, $Ge(R^{T5})_2$, $Sn(R^{T5})_2$, C=O, C=S, C=Se, $C=NR^{T5}$, $P(=O)(R^{T5})$, SO, $SO_2$, $NR^{T5}$, O, S or $CONR^{T5}$;

$C_6$-$C_{60}$-aryl,
which is optionally substituted with one or more substituents $R^{T5}$; $C_3$-$C_{57}$-heteroaryl,
which is optionally substituted with one or more substituents $R^{T5}$;
$R^{T5}$ is at each occurrence independently from another selected from the group consisting of hydrogen, deuterium, $CF_3$, CN, F, Br, I,
$C_1$-$C_{40}$-alkyl,
$C_1$-$C_{40}$-alkoxy,
$C_1$-$C_{40}$-thioalkoxy,
$C_2$-$C_{40}$-alkenyl,
$C_2$-$C_{40}$-alkynyl,
$C_6$-$C_{60}$-aryl,
$C_3$-$C_{57}$-heteroaryl.

**8.** The light-emitting layer according to any of claim 1 to 7, wherein the host compound comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^P$-X:

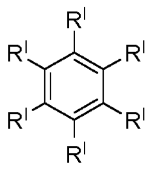

Formula $H^P$-I

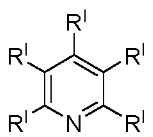

Formula $H^P$-II

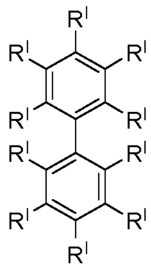

Formula $H^P$-III

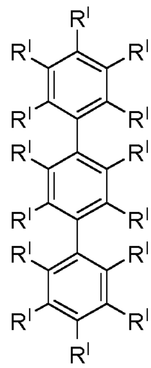

Formula $H^P$-IV

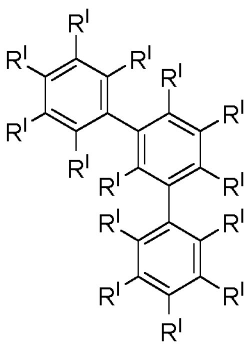

Formula $H^P$-V

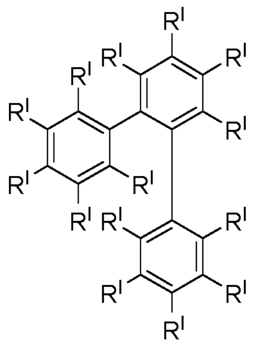

Formula $H^P$-VI

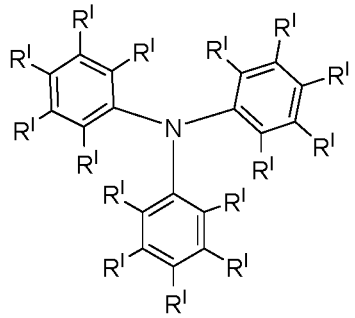

Formula $H^P$-VII

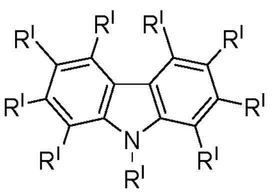

Formula $H^P$-VIII

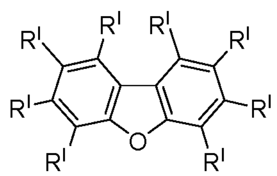

Formula $H^P$-IX

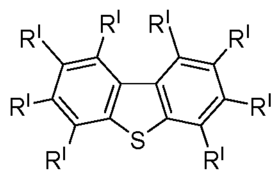

Formula $H^P$-X

and
- one or more second chemical moieties, each comprising or consisting of a structure according to any of

formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

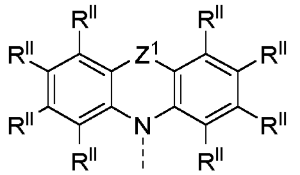

Formula $H^P$-XI

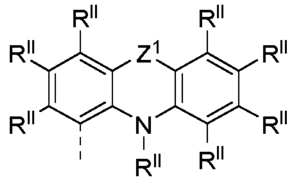

Formula $H^P$-XII

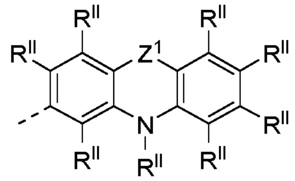

Formula $H^P$-XIII

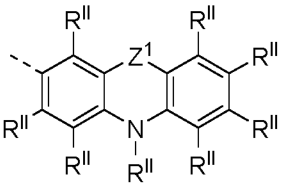

Formula $H^P$-XIV

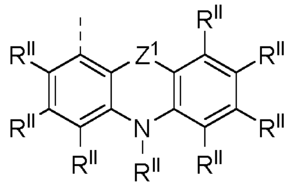

Formula $H^P$-XV

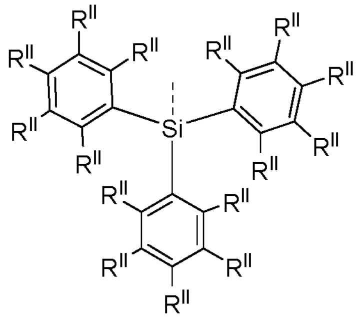

Formula $H^P$-XVI

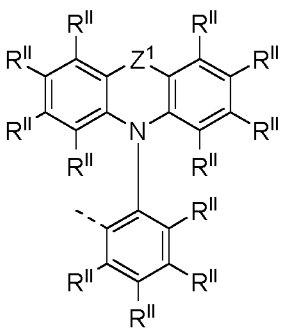

Formula $H^P$-XVII

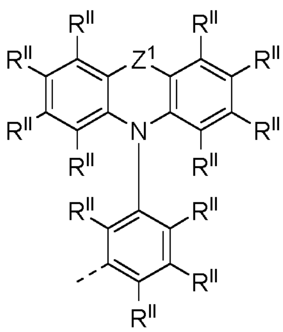

Formula $H^P$-XVIII

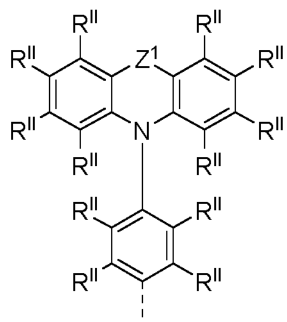

Formula $H^P$-XIX,

wherein each of the one or more second chemical moieties which is present in the host, in particular a p-host material $H^P$, is linked to the first chemical moiety via a single bond which is represented in the formulas above by a dashed line;

wherein

$Z^1$ is at each occurrence independently of each other selected from the group consisting of a direct bond, $C(R^{II})_2$, $C=C(R^{II})_2$, C=O, $C=NR^{II}$, $NR^{II}$, O, $Si(R^{II})_2$, S, S(O) and $S(O)_2$;

$R^I$ is at each occurrence independently of each other a binding site of a single bond linking the first chemical moiety to a second chemical moiety or is selected from the group consisting of hydrogen, deuterium, Me, $^i$Pr, and $^t$Bu, and

Ph, which is optionally substituted with one or more substituents independently of each other selected from the group consisting of: Me, $^i$Pr, $^t$Bu, and Ph;

wherein at least one $R^I$ is a binding site of a single bond linking the first chemical moiety to a second chemical moiety;

R" is at each occurrence independently of each other selected from the group consisting of: hydrogen, deuterium, Me, $^i$Pr, $^t$Bu, and

Ph, which is optionally substituted with one or more substituents independently of each other selected from the group consisting of: Me, $^i$Pr, $^t$Bu, and Ph;

wherein two or more adjacent substituents R" may optionally form a mono- or polycyclic, aliphatic or aromatic

or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents R" comprises in total 8-60 carbon atoms preferably 12-40 carbon atoms, more preferably 14-32 carbon atoms.

**9.** A method for generating a light-emitting layer, comprising the steps:

(i) mixing a first compound and a second compound together to form a homogeneous mixture, wherein the first compound has a different chemical structure than the second compound; wherein the first compound has an evaporation temperature T1 between 150 to 400 °C and the second compound has an evaporation temperature T2 between 150 and 400 °C; wherein the evaporation temperature is measured in the vacuum deposition chamber at a deposition rate of 0.08 nm/sec (0.8 Å/sec) at a constant pressure $1.33\times10^{-4}$ Pa ($1\times10^{-6}$ Torr) to $1.33\times10^{-6}$ Pa ($1\times10^{-8}$ Torr); wherein the temperature difference T1-T2 is in a range between -40 °C to 40 °C, preferably between -20 °C and 20 °C, more preferably between -10 °C and 10 °C; wherein the first and second compound each is selected from a host material and a TADF emitter, wherein at least one of the first compound and the second compound is a TADF emitter; and
(ii) evaporating the homogeneous mixture of the first compound and the second compound together out of one container, wherein further compounds can optionally be co-evaporated out of one or more further containers.

**10.** The method according to claim 9, wherein the organic electroluminescent device comprises a light emitting layer comprising at least:

(i) the first compound;
(ii) the second compound;
(iii) one small FWHM emitter and
(iv) a phosphorescent emitter.

**11.** The method according to claim 9 or 10 comprising the steps

(i) Providing a composition according to any of claims 1 to 8;
(ii) Optionally homogenizing of the composition by

a. grinding, and/or
b. liquefying the composition by heating above the melting temperature of the first compound and the second compound depending on which compound has the higher melting point and subsequent cooling, and/or
c. dissolving the composition in a solvent or a mixture of solvents and subsequent removal of the solvent;

(iii) Evaporation of the composition; and
(iv) Optional co-evaporation of additional compounds.

Europäisches Patentamt
European Patent Office
Office européen des brevets

# EUROPEAN SEARCH REPORT

Application Number
EP 22 15 5250

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 028 913 A (BEIJING ETERNAL MAT TECH CO LTD) 4 December 2020 (2020-12-04)<br>* example 9 *<br>* in particular T-22;<br>paragraph [0155] - paragraph [0157];<br>compounds T-11, T-12, T-14, T-15, T-18, T-22, T-23 *<br>* the whole document *<br>----- | 1-11 | INV.<br>C09K11/06<br>H01L51/50 |
| X<br>A | US 2012/248968 A1 (OGIWARA TOSHINARI [JP] ET AL) 4 October 2012 (2012-10-04)<br>* example 1 *<br>----- | 1-6,8-11<br>7 | |
| X | CN 112 625 032 A (NINGBO LUMILAN NEW MAT CO LTD) 9 April 2021 (2021-04-09)<br>* example 1; table 1 in 200; claims 5-7; I-30, II-12, II-1 *<br>* the whole document *<br>----- | 1-11 | |
| A | WO 2020/085842 A1 (LG CHEMICAL LTD [KR]) 30 April 2020 (2020-04-30)<br>* TADF molecules;<br>page 59 - page 66 *<br>* light-emitting layer may comprise a host;<br>paragraph [0220] *<br>----- | 1-11 | TECHNICAL FIELDS SEARCHED (IPC)<br>C09K<br>H01L |
| X | WO 2021/066370 A1 (LG DISPLAY CO LTD [KR]; ROHM & HAAS ELECT MATERIALS KOREA LTD [KR]) 8 April 2021 (2021-04-08)<br>* compound A;<br>paragraphs [0292], [0296]; claim 7 *<br>* the whole document *<br>----- | 1-11 | |
| A | WO 2022/015084 A1 (LG CHEMICAL LTD [KR]) 20 January 2022 (2022-01-20)<br>* page 416, second row, last compound *<br>* the whole document *<br>----- | 7 | |

The present search report has been drawn up for all claims

1

| Place of search | Date of completion of the search | Examiner |
|---|---|---|
| The Hague | 20 June 2022 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 15 5250

This annex lists the patent family members relating to the patent documents cited in the above-mentioned European search report. The members are as contained in the European Patent Office EDP file on
The European Patent Office is in no way liable for these particulars which are merely given for the purpose of information.

20-06-2022

| Patent document cited in search report | | Publication date | Patent family member(s) | | Publication date |
|---|---|---|---|---|---|
| CN 112028913 | A | 04-12-2020 | NONE | | |
| US 2012248968 | A1 | 04-10-2012 | CN 103443949 | A | 11-12-2013 |
| | | | CN 105762279 | A | 13-07-2016 |
| | | | EP 2690681 | A1 | 29-01-2014 |
| | | | EP 3598520 | A1 | 22-01-2020 |
| | | | JP 5889280 | B2 | 22-03-2016 |
| | | | JP WO2012133188 | A1 | 28-07-2014 |
| | | | KR 20140015385 | A | 06-02-2014 |
| | | | KR 20160101214 | A | 24-08-2016 |
| | | | TW 201248965 | A | 01-12-2012 |
| | | | TW 201638086 | A | 01-11-2016 |
| | | | US 2012248968 | A1 | 04-10-2012 |
| | | | US 2014103329 | A1 | 17-04-2014 |
| | | | US 2017149007 | A1 | 25-05-2017 |
| | | | US 2021074941 | A1 | 11-03-2021 |
| | | | WO 2012133188 | A1 | 04-10-2012 |
| CN 112625032 | A | 09-04-2021 | NONE | | |
| WO 2020085842 | A1 | 30-04-2020 | CN 112533900 | A | 19-03-2021 |
| | | | KR 20200047418 | A | 07-05-2020 |
| | | | WO 2020085842 | A1 | 30-04-2020 |
| WO 2021066370 | A1 | 08-04-2021 | CN 112913041 | A | 04-06-2021 |
| | | | KR 20210039565 | A | 12-04-2021 |
| | | | US 2021313519 | A1 | 07-10-2021 |
| | | | WO 2021066370 | A1 | 08-04-2021 |
| WO 2022015084 | A1 | 20-01-2022 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1156536 A
- US 10074806 B
- EP 2690681 A1